# EUROPEAN PATENT SPECIFICATION

(11) **EP 4 048 747 B1**
(45) Date of publication and mention of the grant of the patent: **18.02.2026**
(21) Application number: 20878805.9
(22) Date of filing: 22.10.2020
(51) Int. Cl.: C09G 1/02, C09K 3/14, H01L 21/3105, H01L 21/02, C01F 17/235, C01F 17/241

(54) **SELF-STOPPING POLISHING COMPOSITION AND METHOD**
SELBSTSTOPPENDE POLIERZUSAMMENSETZUNG UND VERFAHREN
COMPOSITION ET PROCÉDÉ DE POLISSAGE À ARRÊT AUTOMATIQUE

(30) Priority: 22.10.2019 US 201962924342 P
(43) Date of publication of application: 31.08.2022
(73) Proprietor: CMC Materials LLC, Wilmington, DE 19801 (US)
(72) Inventor: CHANG, Juyeon, Aurora, Illinois 60504 (US); BROSNAN, Sarah, Aurora, Illinois 60504 (US); JOHNSON, Brittany, Aurora, Illinois 60504 (US); WANG, Jinfeng, Aurora, Illinois 60504 (US); HAINS, Alexander, W., Aurora, Illinois 60504 (US)
(74) Representative: Barker Brettell LLP
(86) International application number: PCT/US2020/056807
(87) International publication number: WO 2021/081171

(56) References cited:
- WO-A1-2018/194792
- WO-A1-2018/229005
- WO-A1-2019/099655
- WO-A1-2019/177802
- CN-A- 109 251 673
- US-A1- 2018 244 956
- US-B2- 8 728 341

## Description

### CROSS REFERENCE TO RELATED APPLICATIONS

This application claims the benefit of U.S. Provisional Application Ser. No. 62/924,342 entitled Self-Stopping Polishing Composition and Method, filed October 22, 2019.

### BACKGROUND OF THE INVENTION

Chemical mechanical polishing is a key enabling technology in integrated circuit (IC) and micro-electro-mechanical systems (MEMS) fabrication. CMP compositions and methods for polishing (or planarizing) the surface of a substrate (such as a wafer) are well known in the art. Polishing compositions (also known as polishing slurries, CMP slurries, and CMP compositions) commonly include abrasive particles suspended (dispersed) in an aqueous solution and chemical additives for increasing the rate of material removal, improving planarization efficiency, and/or reducing defectivity during a CMP operation.

It is desirable in certain polishing applications for a CMP composition to exhibit "self-stopping" behavior such that when a large percentage of the "high points" of the surface (i.e., raised areas) have been removed, the removal rate decreases. In self-stopping polishing applications, the removal rate is effectively high while a significant step height is present at the substrate surface and then the removal rate is lowered as the surface becomes essentially planar. In various dielectric polishing steps (e.g., in an STI process) the rate of removal of pattern dielectric material (e.g., dielectric layer) is typically a rate-limiting factor of the overall process. Therefore, high removal rates of pattern dielectric material are desired to increase throughput. Good efficiency in the form of relatively low trench loss is also desirable. Further, if the removal rate of dielectric remains high after achieving planarization, overpolishing occurs, resulting in added trench loss.

Advantages of self-stopping slurries result from the reduced blanket removal rate, which produces a wide endpoint window. For example, self-stopping behavior allows for polishing of substrates having reduced dielectric film thickness, allowing for a reduced amount of material to be deposited over a structured lower layer. Also, motor torque endpoint detection can be used for more effective monitoring of final topography. Substrates can be polished with lower trench loss by avoiding overpolishing or unnecessary removal of dielectric after planarization.

Cerium oxide (ceria) abrasives are well known in the industry, particularly for polishing silicon containing substrates, for example, including silicon oxide materials, such as tetraethylorthosilicate (TEOS), silicon nitride, and/or polysilicon. Ceria abrasive compositions are commonly used in advanced dielectric applications, for example including shallow trench isolation applications. While the use of ceria abrasives is known, there remains a need for improved ceria abrasive based CMP compositions. In particular, there remains a need for compositions and methods for chemical-mechanical polishing of silicon oxide-containing substrates that will provide useful removal rates while also providing improved planarization efficiency

Documents US2018/244956 A1, WO2018/229005 A1 and WO2018/194792 A1 represent relevant background of the invention.

### BRIEF SUMMARY OF THE INVENTION

A chemical mechanical polishing composition for polishing a substrate having a silicon oxygen material (such as silicon oxide) is disclosed. In one embodiment, the polishing composition comprises, consists of, or consists essentially of a liquid carrier, cubiform ceria abrasive particles dispersed in the liquid carrier, a self-stopping agent, and a cationic polymer.

### BRIEF DESCRIPTION OF THE DRAWINGS

For a more complete understanding of the disclosed subject matter, and advantages thereof, reference is now made to the following descriptions taken in conjunction with the accompanying drawings, in which:
FIGS. 1 and 2 depict transmission electron microscopy (TEM) micrographs of a cubiform ceria abrasive sample showing ceria abrasive particles having square faces.
FIG. 3 depicts a scanning electron microscopy (SEM) micrograph of a cubiform ceria abrasive sample showing ceria abrasive particles having square faces.
FIG. 4 depicts a plot of active loss in units of Å versus pattern type for the patterned wafers polished in Example 6.

### DETAILED DESCRIPTION OF THE INVENTION

A chemical mechanical polishing composition for polishing a substrate having a silicon oxygen material (such as silicon oxide) is disclosed. The polishing composition comprises, consists of, or consists essentially of a liquid carrier, cubiform ceria abrasive particles dispersed in the liquid carrier, a self-stopping agent, and a cationic polymer. In one embodiment the self-stopping agent includes benzhydroxamic acid, salicylhydroxamic acid, kojic acid, or potassium sorbate. In another embodiment, the cationic polymer includes poly(vinylimidazolium), poly(methacryloyloxyethyl trimethylammonium), polylysine, or Polyquaternium-7.

The disclosed polishing compositions and corresponding (CMP methods) may confer significant and unexpected advantages. For example, the disclosed compositions may provide significantly improved active oxide removal rates and may therefore improve throughput and save time and money (i.e., via improving planarization time). The disclosed compositions may further provide improved planarization over a wide range of patterned oxide structures. The disclosed composition may further provide improved/reduced trench loss and improved self-stopping behavior (reduced blanket rates).

The polishing composition contains abrasive particles including cubiform cerium oxide abrasive particles suspended in a liquid carrier. By "cubiform" it is meant that the ceria abrasive particles are in the form or shape of a cube, i.e., substantially cubic. Stated another way, the cubiform ceria abrasive particles are cubic in form or nature. However, it will be understood that the edge dimensions, corners, and corner angles need not be exactly or precisely those of a perfect cube. For example, the cubiform abrasive particles may have slightly rounded or chipped corners, slightly rounded edges, edge dimensions that are not exactly equal to one another, corner angles that are not exactly 90 degrees, and/or other minor irregularities and still retain the basic form of cube. One of ordinary skill in the art will be readily able to recognize (e.g., via scanning electron microscopy or transmission electron microscopy) that the cubiform ceria abrasive particles are cubic in form with tolerances generally allowed for particle growth and deagglomeration.

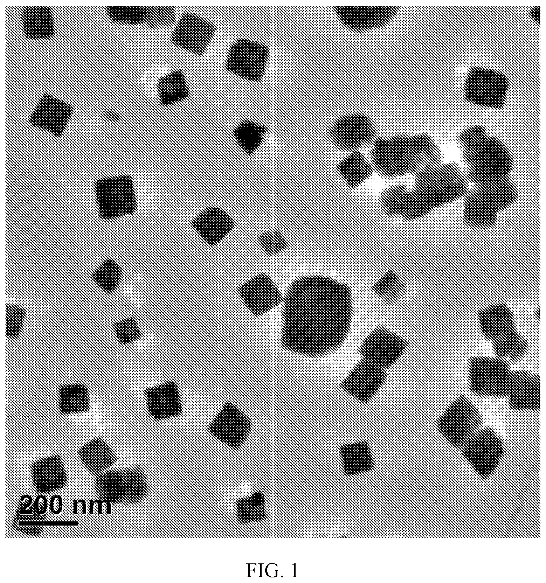

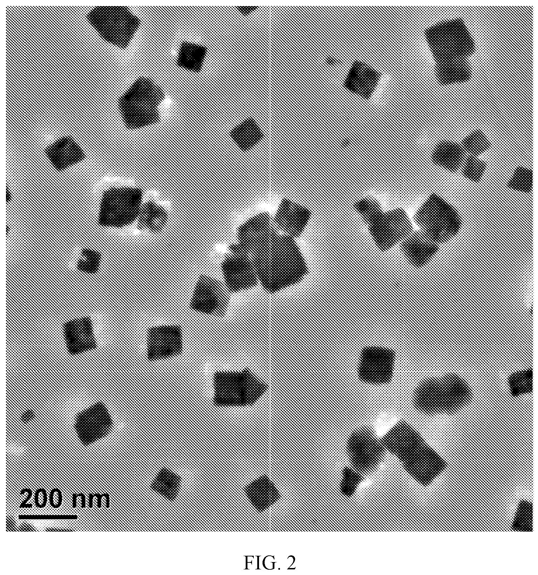

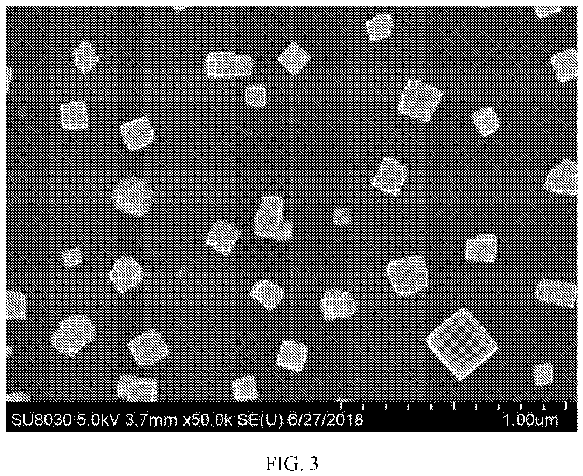

FIGS. 1, 2, and 3 depict example cubiform ceria abrasive particles. These transmission electron microscopy (TEM) and scanning electron microscopy (SEM) images depict ceria abrasive particles having square faces. For example, in these images the depicted particle faces each include four edges having substantially the same length (e.g., within 20 percent of one another or even within 10 percent or less of one other). Moreover the edges meet at corners at approximately 90 degree angles (e.g., within a range from about 80 to 100 degrees or from about 85 to about 95 degrees). One of ordinary skill in the art will readily appreciate that in the TEM and SEM images a significant majority of the depicted abrasive particles are cubiform in that they have square faces as defined above. Some of the particles may be observed to include defects, for example, on one or more corners. Again, it will be understood that the term cubiform is not intended to describe ceria abrasive particles that are precisely cubic, but rather particles that are generally cubic in nature as described above and depicted in FIGS 1, 2, and 3.

As used herein, a chemical mechanical polishing composition including a cubiform ceria abrasive is one in which at least 25 number percent of the abrasive particles are cubic in nature (cubic in form or shape as described above). In preferred embodiments, at least 40 number percent (e.g., at least 60 percent, or at least 80 percent) of the abrasive particles are cubic in nature. As noted above, the cubiform ceria abrasive particles may be readily evaluated and counted using TEM or SEM images, for example, at a magnification in a range from about 10,000x to about 500,000x. SEM or TEM images show abrasive particles having faces with four sides with similar length (e.g., within 20 percent of one another as described above). The images also show that adjacent sides are approximately perpendicular, for example, forming an angle of about 90 degrees (e.g., within a range from about 80 to about 100 degrees as also described above). To determine whether or not a ceria abrasive composition includes cubiform ceria abrasive particles, SEM or TEM observation shall be made on a large number of randomly selected particles (i.e., more than 200) so that it is possible to perform a statistical analysis and thereby determine a percentage of the particles that have a square face. The particles retained must be such that their images are well visible on the micrographs. Some of the particles may exhibit some defects either on their surface and/or one or more of their corners and still be counted as being cubiform.

The cubiform ceria abrasive particles may be substantially pure ceria abrasive particles (within normal tolerances for impurities) or doped ceria abrasive particles. Doped ceria abrasive particles may include interstitial dopants (dopants that occupy a space in the lattice that is not normally occupied) or substitutional dopants (dopants that occupy a space in the lattice normally occupied by cerium or oxygen atoms). Such dopants may include substantially any metal atom, for example, including Ca, Mg, Zn, Zr, Sc, or Y.

In certain advantageous embodiments, the dopants may include one or more Lanthanides, for example, including lanthanum, praseodymium, neodymium, promethium, samarium, and the like. In one particularly suitable embodiment, the cubiform ceria abrasive particles include a mixed oxide of cerium and lanthanum. The mixed oxide abrasive particles may have a molar ratio of La to (La + Ce) in range from about 0.01 to about 0.15, for example, from about 0.01 to about 0.12. It will be understood that such abrasive particles may additionally include other elements and/or oxides (e.g., as impurities). Such impurities may originate from the raw materials or starting materials used in the process of preparing the abrasive particles. The total proportion of the impurities is preferably less than 0.2% by weight of the particle. Residual nitrates are not considered as impurities.

In certain embodiments, the molar ratio of La to (La + Ce) may be in a range from about 0.01 to about 0.04 (e.g., from about 0.02 to about 0.03). In one such embodiment, the cubiform ceria abrasive particles include about 2.5 mole percent lanthanum oxide and about 97.5 mole percent cerium oxide. In other embodiments, the molar ratio may be in a range from about 0.08 to about 0.12 (e.g., from about 0.09 to about 0.11). In one such other embodiment the cubiform ceria abrasive particles include about 10 mole percent lanthanum oxide and about 90 mole percent cerium oxide. The abrasive particles may be a single phase solid solution with the lanthanum atoms substituting cerium atoms in the cerium oxide crystalline structure. In one embodiment, the solid solution exhibits a symmetrical x-ray diffraction pattern with a peak located between about 27 degrees and about 29 degrees that is shifted to a lower angle than pure cerium oxide. A solid solution may be obtained when the temperature of the aging sub-step (described below) is higher than about 60 degrees C. As used herein the term "solid solution" means that x-ray diffraction shows only the pattern of the cerium oxide crystal structure with or without shifts in the individual peaks but without additional peaks that would indicate the presence of other phases.

The cubiform ceria abrasive particles may also optionally be characterized by their specific surface area as determined on a powder by adsorption of nitrogen using the Brunauer-Emmett-Teller method (BET method). The method is disclosed in ASTM D3663-03 (reapproved 2015). The abrasive particles may have a specific surface area in a range from about 3 to about 14 m²/g (e.g., from about 7 to about 13 m²/g or from about 8 to about 12 m²/g).

The cubiform ceria abrasive particles may optionally also be characterized by their average particle size and/or particle size distribution. The abrasive particles may have an average particle size in a range from about 50 nm to about 1000 nm (e.g., from about 80 nm to about 500 nm, from about 80 nm to about 250 nm, from about 100 nm to about 250 nm, or from about 150 nm to about 250 nm). Moreover, the average particle size may be greater than about 50 nm (e.g., greater than about 80 nm or greater than about 100 nm). The average particle size may be determined via dynamic light scattering (DLS) and corresponds to a median particle diameter (D50). DLS measurements may be made, for example, using a Zetasizer (available from Malvern Instruments). Those of ordinary skill in the art will readily appreciate that DLS measurements may significantly under count small particles when measured in the presence of comparatively larger particles. For the cubiform ceria abrasive particles disclosed herein the DLS technique tends to under count particles below about 40 nm. It will be understood that the disclosed embodiments may include a significant number of such small particles (less than 40 nm) that are not counted by DLS and therefore do not contribute to the average particles size.

Laser diffraction techniques may also optionally be used to characterize particle size distribution. Those of ordinary skill in the art will readily appreciate that laser diffraction techniques also tend to under count small particles (e.g., less than 40 nm in the disclosed embodiments). Laser diffraction measurements may be made, for example, using the Horiba LA-960 using a relative refractive index of 1.7. From the distribution obtained with laser diffraction measurements, various parameters may be obtained, for example, including D10, D50, D90, D99 and the dispersion index (defined below). Based on laser diffraction measurements, the abrasive particles may include a median diameter (D50) in a range from about 100 nm to about 700 nm (e.g., from about 100 nm to about 200 nm). For example, D50 may be in a range from about 100 nm to about 150 nm or from about 150 nm to about 200 nm. D50 is the median diameter determined from a distribution obtained by laser diffraction.

The cubiform ceria abrasive particles may optionally have a D10 in a range from about 80 nm to about 400 nm (e.g., from about 80 nm to about 250 nm, from about 80 nm to about 150 nm, or from about 100 nm to about 130 nm). It will be understood that D10 represents the particle diameter obtained by laser diffraction for which 10% of the particles have a diameter of less than D10.

The cubiform ceria abrasive particles may optionally have a D90 in a range from about 150 nm to about 1200 nm (e.g., from about 150 nm to about 1000 nm, from about 150 to about 750 nm, from about 150 to about 500 nm, from about 150 to about 300 nm, or from about 200 nm to about 300 nm). D90 represents the particle diameter obtained by laser diffraction for which 90% of the particles have a diameter of less than D90. Abrasive particles having undergone mechanical deagglomeration may have a D90 less than about 300 nm.

The cubiform ceria abrasive particles may optionally exhibit a low dispersion index. The "dispersion index" is defined by the following formula dispersion index = (D90-D10)/2·D50. The dispersion index may be less than about 0.60, for example (less than about 0.5, less than about 0.4, or less than about 0.30). Abrasive particles having undergone mechanical deagglomeration may have a dispersion index less than about 0.30. Moreover, D90/D50 may be in a range from about 1.3 to about 2 for particles having undergone mechanical deagglomeration.

The cubiform ceria abrasive particles may optionally have a D99 in a range from about 150 nm to about 3000 nm (e.g., from about 200 nm to about 2000 nm, from about 200 nm to about 1800 nm, from about 200 nm to about 1200 nm, from about 200 nm to about 900 nm, from about 200 nm to about 600 nm, from about 200 to about 500 nm, or from about 200 to about 400 nm). Abrasive particles having undergone mechanical deagglomeration may have a D99 less than about 600 nm (e.g., less than about 500 or less than about 400). D99 represents the particle diameter obtained by laser diffraction for which 99% of the particles have a diameter of less than D99.

The abrasive particles may be prepared using substantially any suitable methodology for producing cubiform ceria abrasive particles. The disclosed embodiments are directed to chemical mechanical polishing compositions including such abrasive particles and to methods for polishing substrates using such abrasive particles and are not limited to any particular methods for producing the particles. In certain embodiments, the cubiform ceria abrasive particles may be prepared by precipitating cerium nitrates (and optionally other nitrates when a doped ceria abrasive is prepared). The precipitated material may then be grown in a specific temperature and pressure regime to promote growth of cubiform ceria abrasive particles. These particles may then be cleaned and deagglomerated. A dispersion of the cubiform ceria abrasive particles may then be prepared and used to formulate the inventive chemical mechanical compositions.

In one advantageous embodiment cubiform cerium lanthanum oxide abrasive particles may be prepared by precipitating nitrates of cerium and of lanthanum. One such preparation method includes the following steps:
(i) Mixing, under an inert atmosphere, an aqueous cerium nitrate solution and an aqueous base.
(ii) Heating the mixture obtained in (i) under an inert atmosphere.
(iii) Optionally acidifying the heat treated mixture obtained in (ii).
(iv) Washing with water the solid material obtained in (ii) or (iii).
(v) Mechanically treating the solid material obtained in (iv) to deagglomerate the ceria particles.

The cerium nitrate solution used in step (i) of the above methodology may be prepared by mixing aqueous solutions of cerium nitrates and lanthanum nitrates. The aqueous solution comprises Ce^{III}, Ce^{IV} and La^{III} and may be characterized by a Ce^{IV} to total Ce molar ratio between about 1/(500,000) and about 1/(4,000). In one example embodiment the molar ratio may be between about 1/(100,000) and about 1/(90,000). It is generally advantageous to use salts and ingredients of a high purity, for example, having a purities of at least 99.5 weight percent or even 99.9 weight percent.

Step (i) includes mixing/reacting the aqueous cerium nitrate solution with an aqueous base. Bases of the hydroxide type may be advantageous, for example, including alkali metal or alkaline earth metal hydroxides and aqueous ammonia. Secondary, tertiary or quaternary amines may also be used. The aqueous solution of the base may also be degassed (deoxygenated) beforehand by bubbling with an inert gas. The mixing may be implemented by introducing the aqueous cerium nitrate solution into the aqueous base and is advantageously carried out under an inert atmosphere, for example, in a closed reactor or in a semi-closed reactor with inert gas (e.g., nitrogen or argon) purging. The mixing may also be carried out with stirring. The molar ratio of base to (Ce + La) may be between about 8.0 and about 30.0 (e.g., greater than about 9.0). Step (i) may further be carried out at a temperature between about 5 degrees C and about 50 degrees C, for example, between about 20 degrees C and 25 degrees C.

Step (ii) includes heating the mixture obtained at the end of the preceding step and may include a heating sub-step and an aging sub-step. The heating sub-step may include heating the mixture to a temperature in range from about 75 degrees C to about 95 degrees C, for example, from about 85 degrees C to about 90 degrees C. The aging sub-step may include maintaining (holding) the mixture at the temperature for a duration in a range from about 2 hours to about 20 hours. In general the aging time decreases with increasing temperature. Step (ii) may also be carried out under an inert atmosphere and stirring as described above for step (i).

In step (iii), the mixture obtained at the end of step (ii) may optionally be acidified, for example, using nitric acid. The heat treated reaction mixture may be acidified, for example, to a pH lower than about 3.0 (e.g., in a range from about 1.5 to about 2.5).

In step (iv), the solid material obtained in step (ii) or (iii) may be washed with water, (e.g., deionized water). The washing may be used to decrease residual nitrates in the final dispersion and to obtain a targeted conductivity. The washing may include filtering the solid from the mixture and redispersing the solid in water. Filtration and redispersion may be performed several times if necessary.

In step (v), the washed solid material obtained in (iv) may optionally be mechanically treated to deagglomerate or partially deagglomerate the ceria abrasive particles. Mechanical treatment may include, for example, double jet treatment or ultrasonic deagglomeration and usually results in a narrow particle size distribution and to a reduction of the number of large agglomerated particles.

After step (iv) or (v), the solid material may be dried to obtain the cerium-based particles in the powder form. The powder may be redispersed by adding water or a mixture of water and of a miscible liquid organic compound to obtain a dispersion of the cerium-based particles in a liquid medium. The liquid medium may be water or a mixture of water and of a water-miscible organic liquid. The water-miscible organic liquid may, for example, include an alcohol such as isopropyl alcohol, ethanol, 1-propanol, methanol, 1-hexanol; a ketone such as acetone, diacetone alcohol, methyl ethyl ketone; an ester such as ethyl formate, propyl formate, ethyl acetate, methyl acetate, methyl lactate, butyl lactate, ethyl lactate. The proportion of water to organic liquid may be between 80 to 20 and 99 to 1 parts by weight. Moreover, the dispersion may include from about 1 weight percent to about 40 weight percent of the cerium-based particles, e.g., between about 10 weight percent and about 35 weight percent. The dispersion may also have a conductivity less than about 300 µS/cm, for example, less than about 150 more particularly lower than 150 µS/cm or less than about 100 µS/cm.

The polishing composition may include substantially any suitable amount of the cubiform ceria abrasive particles. For example, the polishing composition may include about 0.001 weight percent (10 ppm) or more of the cubiform ceria abrasive particles at point of use (e.g., about 0.002 weight percent or more, about 0.005 weight percent or more, about 0.01 weight percent or more, about 0.02 weight percent or more, about 0.05 weight percent or more, or about 0.1 weight percent or more). The polishing composition may include about 5 weight percent or less of the cubiform ceria abrasive particles at point of use (e.g., about 2 weight percent or less, about 1.5 weight percent or less, about 1 weight percent or less, or about 0.5 weight percent or less). It will be understood that the cubiform ceria abrasive particles may be present in the polishing composition at a concentration bounded by any two of the aforementioned endpoints. For example, the concentration of cubiform ceria abrasive particles in the polishing composition may be in a range from about 0.001 weight percent to about 5 weight percent at point of use (e.g., from about 0.005 weight percent to about 1 weight percent, from about 0.01 weight percent to about 1 weight percent, or from about 0.01 weight percent to about 0.5 weight percent).

An aqueous liquid carrier is used to facilitate the application of the abrasive and any optional chemical additives to the surface of the substrate to be polished (e.g., planarized). By aqueous it is meant that the liquid carrier is made up of at least 50 wt. % water (e.g., deionized water). The liquid carrier may include other suitable non-aqueous carriers, for example, including lower alcohols (e.g., methanol, ethanol, etc.) and ethers (e.g., dioxane, tetrahydrofuran, etc.). Preferably, the liquid carrier consists essentially of or consists of water, and more preferably deionized water.

The polishing composition is generally mildly acidic, neutral, or alkaline having a pH in a range from about 5 to about 10 (e.g., greater than about 5 and/or less than about 10). In certain embodiments, the polishing composition may be neutral or mildly alkaline, having a pH in a range from about 6 to about 10, (e.g., from about 6.5 to about 9.5, or from about 7 to about 9). In such embodiments, the polishing composition may have a pH of about 8 (e.g., from about 7.5 to about 8.5). In an alternative embodiment, the polishing composition is mildly acidic or neutral having a pH in a range from about 5 to about 8 (e.g., from about 5 to about 7 or from about 5 to about 6.5). In one such embodiment, the polishing composition has a pH of about 5 (e.g., from about 5.5 to about 6.5). In one embodiment, the disclosed embodiments provide for excellent self-stopping performance at mildly acidic pH values.

The polishing composition includes a self-stopping agent. Example self-stopping agents are disclosed in commonly assigned U.S. Patent Publication 2019/0185716. The self-stopping agent is a compound that facilitates a relatively high pattern removal rate and a relatively low blanket removal rate and further facilitates transitioning from a high pattern removal rate to a relatively low blanket removal rate upon planarizing the substrate. For example, the self-stopping agent may be a ligand attached to the cubiform ceria abrasive particles. In some polishing applications, the concentration of the self-stopping agent plays a role in the observed effect since at low concentrations, the self-stopping agent may act as a rate enhancer (e.g., a "high" removal rate is observed) and at higher concentrations the self-stopping behavior is observed (e.g., a "stopping" removal rate is observed). Accordingly, some self-stopping agents may have dual action. By way of example, when a polishing composition comprises picolinic acid in lower concentrations, the picolinic acid may function as a rate enhancer. However, when the polishing composition comprises picolinic acid in higher concentrations, the picolinic acid may function as a self-stopping agent. For example, picolinic acid may function as a rate enhancer at point of use concentrations less than about 1000 ppm by weight.

In some embodiments of the invention, the self-stopping agent is of the formula Q-B, where Q is a substituted or unsubstituted hydrophobic group, or a group imparting a steric hindrance, and B is a binding group, such as, -C(O)-C-OH,-C(O)-C-C-OH or -C(O)-OH. The binding group may also be -C(O)-X-OH where X is a C1-C2 alkyl group. When the self-stopping agent is a compound of the formula Q-B as described herein, Q may be any suitable hydrophobic group, or any suitable group imparting steric hindrance. Suitable hydrophobic groups include saturated and unsaturated hydrophobic groups. The hydrophobic group may be linear or branched, and may include linear or branched alkyl groups, cycloalkyl groups, and ring structures including an aromatic group(s), heterocyclic group(s), heteroaromatic group(s), fused ring systems, and combinations thereof.

Q may be an alkyl group. Suitable alkyl groups include, for example, linear or branched, saturated or unsaturated, substituted or unsubstituted hydrocarbon groups having 1 to 30 carbon atoms (e.g., a C1-C30 alkyl group, a C1-C24 alkyl group, a C1-C18 alkyl group, a C1-C12 alkyl group, or even a C1-C6 alkyl group), for example, at least 1 carbon atom (i.e., methyl), at least 2 carbon atoms (e.g., ethyl, vinyl), at least 3 carbon atoms (e.g., propyl, isopropyl, propenyl, etc.), at least 4 carbon atoms (butyl, isobutyl, sec-butyl, butane, etc.), at least 5 carbon atoms (pentyl, isopentyl, sec-pentyl, neo-pentyl, etc.), at least 6 carbon atoms (hexyl, etc.), at least 7 carbon atoms, at least 8 carbon atoms, at least 9 carbon atoms, at least 10 carbon atoms, at least 11 carbon atoms, at least 12 carbon atoms, at least 13 carbon atoms, at least 14 carbon atoms, at least 15 carbon atoms, at least 16 carbon atoms, at least 17 carbon atoms, at least 18 carbon atoms, at least 19 carbon atoms, at least 20 carbon atoms, at least 25 carbon atoms, or at least 30 carbon atoms.

A substituted group refers to a group in which one or more carbon-bonded hydrogens is replaced by a non-hydrogen atom. Illustrative substituents include, for example, hydroxyl groups, keto groups, esters, amides, halogens (e.g., fluorine, chlorine, bromine, and iodine), amino groups (primary, secondary, tertiary, and/or quaternary), and combinations thereof.

Q may be a cycloalkyl group. Suitable cycloalkyl groups include, for example, saturated or unsaturated, substituted or unsubstituted cycloalkyl groups having 3 to 20 carbon atoms (e.g., C3-C20 cyclic group). For example, suitable cycloalkyl groups include cyclopropyl, cyclobutyl, cyclopentyl, cyclohexyl, cycloheptyl, cyclooctyl, cyclononyl, and combinations thereof. In addition, suitable unsaturated cycloalkyl groups include, for example, cyclobutene, cyclopentene, cyclohexene, and combinations thereof.

Q may be an aromatic group. Suitable aromatic groups include, for example, substituted or unsubstituted aromatic groups having 1 to 20 carbon atoms. For example, suitable aromatic groups include phenyl, benzyl, naphthyl, azulene, anthracene, pyrene, and combinations thereof.

Q may be a heteroaromatic group. A "heteroatom" is defined herein as any atom other than carbon and hydrogen atoms. Suitable heteroatom-containing functional groups include, for example, hydroxyl groups, carboxylic acid groups, ester groups, ketone groups, amino groups (e.g., primary, secondary, and tertiary amino groups), amido groups, imido groups, thiol ester groups, thioether groups, nitrile groups, nitros groups, halogen groups, and combinations thereof.

Suitable heterocyclic groups include, for example, cyclic hydrocarbon compounds containing 1 to 20 carbon atoms and containing nitrogen, oxygen, sulfur, phosphorous, boron, and combinations thereof. The heterocyclic compound may be saturated and unsaturated, substituted or unsubstituted. A heterocyclic compound refers to a 5-, 6-, or 7-membered ring compound having one or more heteroatom atoms (e.g., N, O, S, P, or B)) contained as part of the ring system. Illustrative heterocyclic compounds include, for example, a triazole, aminotriazole, 3-amino-1,2,4-triazole, 3-amino-1,2,4-triazole-5-carboxylic acid, 3-amino-5-mercapto-1,2,4-triazole, 4-amino-5-hydrazino-1,2,4-triazole-3-thiol, thiazole, 2-amino-5-methylthiazole, 2-amino-4-thoazoleacetic acid, a heterocyclic N-oxide, 2-hydroxypyridine-N-oxide, 4-methylmorpholine-N-oxide, and picolinic acid N-oxide, and the like. Other illustrative heterocyclic compounds include, for example, pyrone compounds, pyridine compounds, including regioisomers and stereoisomers, pyrrolidine, delta-2-pyrroline, imidazolidine, delta-2-imidazoline, delta-3-pyrazoline, pyrazolidine, piperidine, piperazine, morpholine, quinuclidine, indoline, isoindoline, chroman, isochromann, and combinations thereof.

Suitable heteroaromatic groups include, for example, pyridine, thiophene, furane, pyrrole, 2H-pyrrole, imidazole, pyrazole, isoxazole, furazan, isothiazole, pyran(2H), pyrazine, pyrimidine, pyridazine, isobenzofuran, indolizine, indole, 3H-indole, 1H-indazole, purine, isoindole, 4aH-carbazole, carbazole, beta-carboline, 2H-chromene, 4H-quinolizine, isoquinoline, quinoline, quinoxalin, 1,8-naphthyridine, phthalazine, quinazoline, cinnoline, pteridine, xanthenes, phenoxathiin, phenothiazine, phenazine, perimidine, 1,7-phenantrholine, phenanthridine, acridine, and combinations thereof.

In some embodiments, Q is substituted with one or more substituents. Suitable substituents may include, for example, any suitable compound/group described herein. For example, suitable substituents include alkyl groups, cycloalkyl groups, aryl groups, heterocyclic groups, heteroaromatic groups, and combinations thereof.

In some embodiments, Q is unsubstituted. In other embodiments, Q is a group that imparts a steric hindrance. For example, Q may not be particularly hydrophobic, but may be a bulky constituent that prevents chemical reactions or interactions that would otherwise occur in related molecules with smaller Q groups. Without limitation, examples of self-stopping agents having such a Q group would be maltol, ethyl maltol and kojic acid.

In some embodiments, the binding group B is selected from a carboxylic acid group, a hydroxamic acid group, a hydroxylamine group, a hydroxyl group, a keto group, a sulfate group, a phosphate group, and combinations thereof.

In some embodiments, the self-stopping agent Q-B is selected from kojic acid, maltol, ethyl maltol, propyl maltol, hydroxamic acid, benzhydroxamic acid (benzohydroxamic acid), tiglic acid, angelic acid, salicylhydroxamic acid, benzoic acid, 3,4-dihydroxybenzoic acid, 3,5-dihydroxybenzoic acid, caffeic acid, sorbic acid, potassium sorbate, and combinations thereof. It will be understood that salts of the self-stopping agents of the formulation Q-B also are suitable for use in the inventive polishing compositions.

The polishing composition may comprise any suitable amount of the self-stopping agent (e.g., a compound of the formula Q-B). If the composition comprises too little self-stopping agent, then the composition may not exhibit suitable self-stopping behavior. In contrast, if the polishing composition comprises too much self-stopping agent, the composition may exhibit undesirable polishing performance (e.g., low removal rates), may not be cost effective, and/or may lack stability. One advantageous attribute of the inventive compositions is that the use of the stopping agent in combination with the cubiform ceria abrasive particles enables the use of higher concentrations of the self-stopping agent. Such inventive compositions may advantageously provide superior active removal rates, superior self-stopping behavior, and superior planarization.

For example, the polishing composition may include about 10 ppm by weight (0.001 weight percent) or more of the self-stopping agent at point of use (e.g., about 20 ppm by weight or more, about 50 ppm by weight or more, about 100 ppm by weight or more, about 200 ppm by weight or more, about 250 ppm by weight or more, or even about 500 ppm by weight or more). Accordingly, the polishing composition may comprise from about 10 ppm by weight to about 2 weight percent of the self-stopping agent at point of use. For example, the polishing composition may include from about 20 ppm by weight to about 1 weight percent (10,000 ppm) of the self-stopping agent (e.g., from about 50 ppm by weight to about 10,000 ppm by weight, from about 100 ppm by weight to about 10,000 ppm by weight, from about 200 ppm by weight to about 5000 ppm by weight, or from about 250 ppm by weight to about 2500 ppm by weight) at point of use. In certain advantageous embodiments the polishing composition includes from about 500 ppm by weight to about 2000 ppm by weight of the self-stopping agent at point of use.

The polishing composition may further comprise a cationic polymer (e.g., also referred to as a planarizing agent or a topography control agent). The cationic polymer may include substantially any suitable cationic polymer and may be selected from cationic homopolymers and/or cationic copolymers including at least one cationic monomer and at least one nonionic monomer.

The cationic homopolymer may be any suitable cationic homopolymer including cationic monomer repeat units, for example, including quaternary amine groups as repeat units. The quaternized amine groups may be acyclic or incorporated into a ring structure. Quaternized amine groups include tetrasubstituted nitrogen atoms substituted with four groups independently selected from alkyl, alkenyl, aryl, or arylalkyl groups. When included into a ring structure, quaternized amine groups include either a heterocyclic saturated ring including a nitrogen atom and further substituted with two groups as described above or a heteroaryl group (e.g., imidazole or pyridine) having a further group as described above bonded to the nitrogen atom. Quaternized amine groups possess a positive charge (i.e., are cations having associated anionic moieties, thereby forming salts). It also is suitable for the cationic polymer to be further modified by alkylation, acylation, ethoxylation, or other chemical reaction, in order to alter the solubility, viscosity, or other physical parameter of the cationic polymer. Suitable quaternary amine monomers include, for example, quaternized vinylimidazole (vinylimidazolium), poly(vinylimidazole), methacryloyloxyethyltrimethylammonium (MADQUAT), diallyldimethylammonium (DADMA), methacrylamidopropyltrimethylammonium (MAPTA), quaternized dimethylaminoethyl methacrylate (DMAEMA), and combinations thereof. It will be appreciated that MADQUAT, DADMA, MAPTA, and DMAEMA commonly include a counter anion such as a carboxylate (e.g., acetate) or a halide anion (e.g., chloride). The disclosed embodiments are not limited in this regard.

The cationic polymer may also be a copolymer including at least one cationic monomer (e.g., as described in the preceding paragraph) and at least one nonionic monomer. Non limiting examples of suitable nonionic monomers include vinylpyrrolidone, vinylcaprolactam, vinylimidazole, acrylamide, vinyl alcohol, polyvinyl formal, polyvinyl butyral, poly(vinyl phenyl ketone), vinylpyridine, polyacrolein, ethylene, propylene, styrene, epichlorohydrin, and combinations thereof.

Example cationic polymers include, for example, poly(vinylimidazole), poly(vinylimidazolium), poly(methacryloyloxyethyltrimethylammonium) (polyMADQUAT), poly(diallyldimethylammonium) (e.g., polyDADMAC), poly(diallyldimethylammonium-co-acrylamide), poly(dimethylamine-co-epichlorohydrin), poly[bis(2-chloroethyl) ether-alt-1,3-bis[3-(dimethylamino)propyl]urea] (i.e. Polyquaternium-2), copolymers of vinylpyrrolidone and quaternized dimethylaminoethyl methacrylate (i.e. Polyquaternium-11), copolymers of vinylpyrrolidone and quaternized vinylimidazole (i.e. Polyquaternium-16), a terpolymer of vinylcaprolactam, vinylpyrrolidone, and quaternized vinylimidazole (i.e. Polyquaternium-46), and 3-Methyl-1-vinylimidazolium methyl sulfate-N-vinylpyrrolidone copolymer (i.e. Polyquaternium-44). Additionally, suitable cationic polymers include cationic polymers for personal care such as Luviquat^{®} Supreme, Luviquat^{®} Hold, Luviquat^{®} UltraCare, Luviquat^{®} FC 370, Luviquat^{®} FC 550, Luviquat^{®} FC 552, Luviquat^{®} Excellence, and combinations thereof.

In certain advantageous embodiments, the cationic polymer may include poly(methacryloyloxyethyltrimethylammonium), for example, polyMADQUAT (e.g., Alco 4773), poly(vinylimidazolium) such as poly(vinylimidazolium) methyl sulfate, and imidazolium compounds such as Luviquat^{®} Ultracare.

In certain embodiments, the cationic polymer may additionally or alternatively include an amino acid monomer (such compounds may also be referred to as polyamino acid compounds). Suitable polyamino acid compounds may include substantially any suitable amino acid monomer groups, for example, including polyarginine, polyhistidine, polyalanine, polyglycine, polytyrosine, polyproline, and polylysine. In certain embodiments, polylysine may be a preferred cationic polymer. It will be understood that polylysine may include ε-polylysine and/or α-polylysine composed of D-lysine and/or L-lysine. The polylysine may thus include α-poly-L-lysine, α-poly-D-lysine, ε-poly-L-lysine, ε-poly-D-lysine, and mixtures thereof. In certain embodiments, the polylysine may be ε-poly-L-lysine. It will further be understood that the polyamino acid compound (or compounds) may be used in any accessible form, e.g., the conjugate acid or base and salt forms of the polyamino acid may be used instead of (or in addition to) the polyamino acid.

The cationic polymer may also (or alternatively) include a derivatized polyamino acid (i.e., a cationic polymer containing a derivatized amino acid monomer unit). For example, the derivatized polyamino acid may include derivatized polyarginine, derivatized polyornithine, derivatized polyhistidine, and/or derivatized polylysine. CMP compositions including derivatized polyamino acid compounds are disclosed in U.S. Provisional Patent Application Serial No. 62/958,033, which is incorporated by reference herein in its entirety.

In such embodiments, the derivatized amino acid monomer includes a derivative group bonded to the alpha amino group of the derivatized amino acid monomer. The derivative group may include substantially any suitable group, for example, including an alkyl carbonyl group, a divalent carboacyl group, an alkyl urea group, an alkyl sulfonate group, an alkyl sulfone group, and an alkyl ester group.

Example alkyl carbonyl groups include an acetyl group, a pivaloyl group, an ethyl carbonyl group, and the like. Example divalent carboacyl groups include a succinyl group, an octenyl succinyl group, a glutaric group, a methyl succinyl group, and the like. Among divalent carboacyl groups, a succinyl group and a glutaric group may be preferred owing to solubility. Example alkyl urea groups include ethyl urea, butyl urea, cyclohexyl urea, and the like. Example alkyl sulfonate groups include methyl sulfonate, dimethyl sulfonate, ethyl sulfonate, propyl sulfonate, butyl sulfonate, penta sulfonate, and the like. Example alkyl sulfone groups include methyl sulfone, ethyl sulfone, propyl sulfone, butyl sulfone, penta sulfone, and the like. Example alkyl ester groups include methyl ester, ethyl ester, propyl ester, butyl ester, penta ester, and the like.

The cationic polymer, when present, may be present in the polishing composition at any suitable concentration. One advantageous attribute of the inventive compositions is that the use of the cationic polymer in combination with the cubiform ceria abrasive particles enables the use of higher concentrations of the cationic polymer. Such inventive compositions may advantageously provide superior active removal rates, superior self-stopping behavior, and particularly superior planarization.

It has been found that the cationic polymer concentration depends strongly on the particular cationic polymer selected and may also depend on the cubiform ceria abrasive concentration and the self-stopping agent concentration. In general, the concentration of cationic polymer at point of use is in a range from about 1 ppm by weight to about 1000 ppm by weight (e.g., from about 5 ppm by weight to about 500 ppm by weight). For example, when the cationic polymer is a poly(vinylimidazolium) compound such as poly(vinylimidazolium) methyl sulfate, the composition may include from about 1 ppm by weight to about 75 ppm by weight at point of use. For example, the concentration of cationic polymer may be in a range from about 5 ppm by weight to about 75 ppm by weight (e.g., from about 5 ppm by weight to about 50 ppm by weight, from about 5 ppm by weight to about 40 ppm by weight, or from about 10 ppm by weight to about 40 ppm by weight).

In another example, when the cationic polymer includes poly(methacryloyloxyethyltrimethylammonium) halide such as polyMADQUAT or an imidazolium compounds such as Luviquat^{®} Ultracare, the composition may include from about 25 ppm by weight to about 1000 ppm by weight at point of use. For example, the concentration of cationic polymer may be in a range from about 75 ppm by weight to about 500 ppm by weight (e.g., from about 100 ppm by weight to about 500 ppm by weight, from about 150 ppm by weight to about 500 ppm by weight, or from about 200 ppm by weight to about 400 ppm by weight).

In still another example, when the cationic polymer includes a polyamino acid compound, such as *ε*-poly-L-lysine, the composition may include from about 5 ppm by weight to about 500 ppm by weight at point of use. For example, the concentration of cationic polymer may be in a range from about 5 ppm by weight to about 400 ppm by weight (e.g., from about 10 ppm by weight to about 300 ppm by weight, from about 15 ppm by weight to about 200 ppm by weight, or from about 20 ppm by weight to about 200 ppm by weight).

The polishing composition may further include a non-polymeric cationic compound (in addition to the cationic polymer). Suitable cationic compounds include 2-(dimethylamino)ethyl acrylate, 2-(dimethylamino)ethyl methacrylate, 3-(dimethylamino)propyl methacrylamide, 3-(dimethylamino)propyl acrylamide, lysine, 3-methacrylamidopropyl-trimethyl-ammonium, 3-acrylamidopropyl-trimethyl-ammonium, diallyldimethylammonium, 2-(acryloyloxy)-N,N,N-trimethylethanaminium, methacryloyloxyethyltrimethylammonium, *N,N-*dimethylaminoethyl acrylate benzyl, *N,N-*dimethylaminoethyl methacrylate benzyl, and combinations thereof.

It will be appreciated that 3-methacrylamidopropyl-trimethyl-ammonium, 3-acrylamidopropyl-trimethyl-ammonium, diallyldimethylammonium, 2-(acryloyloxy)*-N*,*N*,*N-*trimethylethanaminium, methacryloyloxyethyltrimethylammonium, *N,N-dimethylaminoethyl* acrylate benzyl, and *N,N-*dimethylaminoethyl methacrylate benzyl are commonly provided with a counter anion such as a carboxylate or a halide anion. For example, diallyldimethylammonium is commonly provided as diallyldimethylammonium chloride (DADMAC). The disclosed embodiments are not limited in regard to the use of any particular counter anion unless the counter anion is explicitly recited.

In certain embodiments, the non-polymeric compound preferably includes lysine, methacryloyloxyethyltrimethylammonium, 2-(dimethylamino)ethyl methacrylate, diallyldimethylammonium, and mixtures thereof. In one example embodiment disclosed below, the polishing composition advantageously includes diallyldimethylammonium and most preferably includes DADMAC.

When used, the polishing composition may include substantially any suitable amount of the non-polymeric cationic compound (e.g., depending on the particular compound used and the other components and amounts of those components in the composition). In certain embodiments, the amount of the non-polymeric cationic compound may be in a range from about 1 ppm by weight to about 1000 ppm by weight at point of use (e.g., from about 2 ppm by weight to about 500 ppm by weight, from about 5 ppm by weight to about 200 ppm by weight, or from about 10 ppm by weight to about 100 ppm by weight).

The polishing composition may further include a polishing rate control agent. The polishing rate control agent may be a polishing rate enhancer (e.g., enhancing the polishing rate on the oxide pattern) or a polishing rate inhibitor (e.g., inhibiting the polishing rate on the trench oxide). A polishing rate enhancer may include, for example, a carboxylic acid compound that activates the polishing particle or substrate. Suitable rate enhancers include, for example, picolinic acid, nicotinic acid, quinaldic acid, iso-nicotinic acid, acetic acid, and 4-hydroxybenzoic acid. As noted above, picolinic acid may function as either a rate enhancer or inhibitor depending on the concentration and may be advantageous in certain embodiments (e.g., as disclosed in the Examples that follow).

The polishing composition may include substantially any suitable amount of rate control agent. In one embodiment, the polishing composition includes from about 10 ppm by weight (0.001 weight percent) to about 1 weight percent of the rate control agent at point of use (e.g., from about 50 ppm by weight to about 0.5 weight percent, from about 100 ppm by weight to about 0.25 weight percent, or from about 200 ppm by weight to about 1000 ppm by weight).

The polishing composition may still further include a removal rate inhibitor (such as a silicon nitride inhibitor), for example, including an unsaturated carboxylic acid such as an unsaturated monoacid. Suitable unsaturated monoacids may include, for example, acrylic acid, 2-butenoic acid (crotonic acid), 2-pentenoic acid, trans-2-hexenoic acid, trans-3-hexenoic acid, 2-hexynoic acid, 2,4-hexadienoic acid, potassium sorbate, trans-2-methyl-2-butenoic acid, 3,3-dimethylacrylic acid, or a combination thereof, including stereoisomers thereof. In one example embodiment disclosed below, the removal rate inhibitor is crotonic acid.

When used the polishing composition may include substantially any suitable amount of the removal rate inhibitor (e.g., depending on the particular compound used and the other components and amounts of those components in the composition). In certain embodiments, the amount of the removal rate inhibitor may be in a range from about 10 ppm by weight to about 1 weight percent (10000 ppm by weight) at point of use (e.g., from about 20 ppm by weight to about 5000 ppm by weight, from about 50 ppm by weight to about 2000 ppm by weight, or from about 100 ppm by weight to about 1000 ppm by weight).

The polishing composition may yet further include one or both of a pH-adjusting agent and/or a pH buffering agent. The pH-adjusting agent may be substantially any suitable pH-adjusting agent, such as an alkyl amine, an alcohol amine, quaternary amine hydroxide, ammonia, or a combination thereof. In certain embodiments, a suitable pH adjusting agent may include triethanolamine (TEA), tetramethylammonium hydroxide (TMAH or TMA-OH), or tetraethylammonium hydroxide (TEAH or TEA-OH). In one advantageous embodiment, the pH adjusting agent is triethanolamine. The polishing composition may include a sufficient concentration of the pH-adjusting agent to achieve and/or maintain the pH of the polishing composition within the pH ranges set forth above. In one embodiment, the polishing composition includes from about 100 ppm by weight to about 1 weight percent of the pH adjusting agent (e.g., triethanolamine) at point of use.

The polishing composition may include substantially any suitable buffering agent such as phosphates, sulfates, acetates, malonates, oxalates, borates, ammonium salts, azoles and the like. In certain advantageous embodiments, the pH buffering agent may include benzotriazole or bis tris methane. The polishing composition may include a sufficient concentration of the pH-buffering agent to provide a desired buffering capacity at a pH within the pH ranges set forth above. In certain embodiments, the polishing composition may include from about 50 ppm by weight to about 0.5 weight percent of the pH buffering agent (e.g., benzotriazole or bis tris methane) at point of use.

The polishing composition may further include other optional additives, for example including, secondary polishing rate accelerators or inhibitors, dispersants, conditioners, scale inhibitors, chelating agents, stabilizers, and biocides. Such additives are purely optional. The disclosed embodiments are not so limited and do not require the use of any one or more of such additives.

The polishing composition may optionally further include a biocide. The biocide may include substantially any suitable biocide, for example an isothiazolinone biocide such as a methylisothiazolinone or a benzisothiazolone. The amount of biocide in the polishing composition typically is in a range from about 1 ppm by weight to about 100 ppm by weight at point of use, for example from about 5 ppm by weight to about 75 ppm by weight.

The polishing composition may be prepared using any suitable techniques, many of which are known to those skilled in the art. The polishing composition may be prepared in a batch or continuous process. Generally, the polishing composition may be prepared by combining the components thereof in any order. The term "component" as used herein includes the individual ingredients (e.g., the abrasive particles, the self-stopping agent, the cationic polymer, and any optional additives). For example, the self-stopping agent and the cationic polymer may be added to the aqueous carrier (e.g., water) at the desired concentration(s). The pH may then be adjusted (as desired) and the cubiform ceria abrasive added at the desired concentration to form the polishing composition. The polishing composition may be prepared prior to use, with one or more components added to the polishing composition just before use (e.g., within about 1 minute before use, or within about 1 hour before use, or within about 1 or about 7 days before use). The polishing composition also may also be prepared by mixing the components at the surface of the substrate during the polishing operation (e.g., on the polishing pad).

In certain embodiments, the polishing composition may be provided as a "two-pack" system. For example, a first pack may include the cubiform ceria abrasive, a rate control additive, and other optional components and a second pack may include the self-stopping agent, the cationic polymer, and other optional components. The first and second packs may be shipped separately and combined prior to polishing (e.g., within one hour or one day of polishing) or on the polishing pad during the CMP operation.

The polishing composition of the invention may be provided as a concentrate which is intended to be diluted with an appropriate amount of water prior to use. In such an embodiment, the polishing composition concentrate may include the cubiform ceria abrasive particles and other components described above in amounts such that, upon dilution of the concentrate with an appropriate amount of water each component of the polishing composition will be present in the polishing composition in an amount within the appropriate range recited above for each component. For example, the cubiform ceria abrasive particles, the self-stopping agent, the cationic polymer, and other optional additives may each be present in the polishing composition in an amount that is about 3 times (e.g., about 4 times, about 5 times, about 6 times, about 7 times, about 8 times, about 10 times, about 15 times, about 20 times, or about 25 times) greater than the point of use concentration recited above for each component so that, when the concentrate is diluted with an equal volume of water (e.g., 2 equal volumes of water, 3 equal volumes of water, 4 equal volumes of water, 5 equal volumes of water, 6 equal volumes of water, 7 equal volumes of water, 9 equal volumes of water, 14 equal volumes of water, 19 equal volumes of water, or 24 equal volumes of water), each component will be present in the polishing composition in an amount within the ranges set forth above for each component.

In embodiments in which the polishing composition is provided as a two-pack system, either or both of the packs may be provided as a concentrate and require dilution prior to mixing with the other pack. For example, in one embodiment, the first pack is provided as a concentrate such that it includes cubiform ceria abrasive particles at a concentration that is about 3 times (e.g., about 5 times, about 8 times, about 10 times, about 15 times, or about 20 times) greater than the point of use concentrations recited above. The concentrated first pack may be mixed with a suitable quantity of water prior to combining with the second pack. Likewise, the second pack may be provided as a concentrate such that it includes self-stopping agent and cationic polymer concentrations that are about 3 times (e.g., about 5 times, about 8 times, about 10 times, about 15 times, or about 20 times) greater than the point of use concentrations recited above. In such embodiments, the concentrated second pack may be mixed with a suitable quantity of water prior to combining with the first pack. In certain embodiments, both the first and second packs may be diluted with water prior to combining. The disclosed embodiments are not limited in these regards.

The polishing method of the invention is particularly suited for use in conjunction with a chemical mechanical polishing (CMP) apparatus, for example including a platen and a pad affixed thereto. As is known to those of ordinary skill in the art, polishing of the substrate takes place when the substrate is placed in contact with the polishing pad and the polishing composition of the invention and then the polishing pad and the substrate move relative to one another so as to abrade at least a portion of the substrate. The inventive method includes providing the inventive composition described above, contacting a substrate (e.g., a wafer) with the inventive composition, moving the polishing composition relative to the substrate, and abrading the substrate to remove a portion of a silicon oxide material from the substrate and thereby polish the substrate.

The substrate generally includes a patterned dielectric layer, many of which are well known, including various forms of silicon oxide and silicon oxide-based dielectric materials. For example, a dielectric material that includes silicon oxide or silicon oxide-based dielectric layer may comprise, consist of, or consist essentially of any one or more of: tetraethoxysilane (TEOS), high density plasma (HDP) oxide, phosphosilicate glass (PSG), borophosphosilicate glass (BPSG), high aspect ratio process (HARP) oxide, spin on dielectric (SOD) oxide, chemical vapor deposition (CVD) oxide, plasma-enhanced tetraethyl ortho silicate (PETEOS), thermal oxide, or undoped silicate glass.

The inventive method desirably planarizes the patterned dielectric, for example, via reducing an initial step height between raised areas (having initial height) and trenches (having initial trench thickness). To accomplish this planarization effectively and efficiently, the inventive method desirably has high removal rate of raised areas (of active pattern dielectric material) and a substantially lower removal rate of dielectric material of trenches. Most preferably, the inventive method also exhibits self-stopping behavior.

During the inventive method, dielectric material is removed from raised areas (and may be removed from trenches in smaller amounts). Planarization reduces the height of raised areas so that they are essentially "level" with the height of trenches. So, for example, the step height may be reduced to less than 1,000 angstroms (Å) (e.g., to less than 800 Å, less than 500 Å, less than 300 Å, or less than 250 Å). The surface is considered to be effectively planarized upon achieving a reduced (by polishing) step height (i.e., a "remaining" step height) of less than about 1,000 Å.

Depending on the substrate being polished, an initial step height may be at least 1,000 Å, e.g., at least 2,000 Å, or at least 5,000 Å, and may be substantially greater, such as at least 10,000 Å, at least 20,000 Å, at least 30,000 Å, or at least 40,000 Å, measured before beginning a step of CMP processing.

During a CMP operation, the removal rate of pattern dielectric is referred to in the art as "pattern removal rate" or "active removal rate." The active removal rate achieved using a method and polishing composition as described herein may be any suitable rate, and for any given process and substrate will depend in great part on the selected polishing tool parameters and the dimensions (e.g., pitch and width) of the patterned dielectric. In certain advantageous embodiments, the active removal rate is greater than about 4,000 Å/min (e.g., greater than about 5,000 Å/min, greater than about 6,000 Å/min, or even greater than about 10,000 Å/min).

Inventive CMP operations also desirably reduce trench loss. For example, the inventive method may provide a trench loss of less than about 2,000 Å (e.g., less than about 1,500 Å, less than about 1,000 Å, less than about 500 Å, or less than about 250 Å).

A lower trench loss may be reflected in an improved planarization efficiency. As used herein, planarization efficiency refers to step height reduction divided by trench loss. The inventive method may provide a planarization efficiency of at least 4 and preferably greater than 5 or 10 (or greater than 20, or even greater than 50).

The inventive methods may also exhibit self-stopping behavior. By self-stopping it is meant that the removal rate of blanket dielectric material is significantly lower than the removal rate of pattern dielectric material. Self-stopping behavior is considered to occur if a removal rate of blanket dielectric material is less than about 1,000 Å/min. The inventive methods may therefore exhibit blanket dielectric removal rates of less than 1000 Å/min (e.g., less than about 500 Å/min).

By another measure self-stopping behavior may be measured by computing a ratio of the active removal rate of pattern dielectric material to the removal rate of blanket dielectric material. A high ratio indicates good self-stopping behavior. The inventive method may therefore provide a ratio of greater than about 5 (e.g., greater than about 10, greater than about 20, or greater than about 50).

The following examples further illustrate the invention but, of course, should not be construed as in any way limiting its scope. Various substrates were polished using an Applied Materials Mirra^{®} polishing tool (available from Applied Materials, Inc.). Blanket wafers were polished for 60 seconds on the Mirra^{®} at a platen speed of 100 rpm, a head speed of 85 rpm, a downforce of 3 psi, and a slurry flow rate of 150 ml/min. Patterned wafers were polished at the same conditions for 80 seconds. The wafers were polished on a NexPlanar^{®} E6088 pad (available from Cabot Microelectronics Corporation) with *in-situ* conditioning using a Saesol DS8051 conditioner at 6 pounds downforce.

Blanket tetraethylorthosilicate (TEOS), blanket SiN, and patterned TEOS wafers were polished in the Examples that follow. The blanket TEOS wafers were obtained from WRS Materials and included a 20 kÅ TEOS layer. The blanket SiN wafers were obtained from Advantec and included a 5 kÅ PE SiN layer. The patterned TEOS wafers were Silyb and STI1 10kÅ TEOS pattern wafers.

### EXAMPLE 1

A stock cerium oxide dispersion was prepared as follows. A cerium nitrate solution was prepared by combining 13.1 kg of a 3 M trivalent cerium(III) nitrate solution, 0.3 kg of a 3 M lanthanum nitrate solution, 2.0 kg of a 68% nitric acid (HNO₃) solution, 0.5 kg deionized water, and cerium(IV) nitrate at a molar ratio of cerium(IV) to cerium(total) equal to 0.000055. The cerium nitrate solution was then degassed with agitation and nitrogen bubbling in a 20 L vessel.

An aqueous ammonia solution was prepared by combining 75 kg of deionized water and a solution of 13.1 kg of 25% aqueous ammonia (such that the molar ratio of NH₄OH in the aqueous ammonia solution to the total cerium and lanthanum in the cerium nitrate solution was 9.0). The aqueous ammonia solution was then degassed with agitation and nitrogen bubbling in a 100 L vessel jacketed reactor.

The cerium nitrate solution was then added, at ambient temperature, to the aqueous ammonia solution with the same agitation under nitrogen purging. The temperature of the reaction mixture was then increased to 80 °C and held at that temperature for 18 hours. The reaction mixture was then left to cool and upon cooling was acidified to pH 2 by adding 68% nitric acid.

The reaction mixture was then filtrated and washed with deionized water. The washing was repeated when the conductivity of the washing solution was less than 0.04 mS/cm. Deionized water was added to adjust the final cerium oxide concentration to 10 weight percent. The cubiform ceria abrasive particles included 2.5 mole percent lanthanum oxide and 97.5 mole percent cerium oxide.

The BET specific surface area was determined by nitrogen adsorption to be 11.8 m² per gram. The average particle size was 102 nm as measured by Horiba 960 and 140 nm as measured by the Malvern Zetasizer.

### EXAMPLE 2

Two polishing compositions were tested to evaluate TEOS polishing rates and self-stopping behavior on blanket and patterned wafers. Each composition was prepared by combining a first pack (the A pack) with deionized water and a corresponding second pack (the B pack). The A packs included 3500 ppm by weight picolinic acid, 75 ppm by weight Kordex MLX, and 2 weight percent ceria abrasive at pH 4.0. For composition 2A, the ceria abrasive included 2 weight percent of a control ceria (a sintered ceria abrasive used in polishing composition 1C of commonly assigned U.S. Patent 9,505,952). For composition 2B, the ceria abrasive included one part by weight of the stock ceria dispersion described above in Example 1 and four parts by weight deionized water to obtain 2 weight percent of the cubiform ceria. The B packs were identical and included 4000 ppm by weight triethanolamine, 1600 ppm by weight benzotriazole, 250 ppm by weight polyMADQUAT, 1670 ppm by weight benzhydroxamic acid, and 113 ppm by weight Kordex MLX at pH 8.2.

One part of the A pack was first combined with 6 parts deionized water and then further combined with 3 parts of the B pack to obtain point of use compositions that included 0.2 weight percent ceria abrasive, 350 ppm by weight picolinic acid, 1200 ppm by weight triethanolamine, 480 ppm by weight benzotriazole, and 75 ppm by weight polyMADQUAT. The pH of the combined A and B packs was about 7.8.

Blanket TEOS wafers were polished for 60 seconds on a Mirra^{®} tool at the conditions listed above. Blanket TEOS removal rates are shown in Table 1 in angstroms per minute (A/min). Patterned wafers were polished for 80 seconds on a Mirra^{®} tool at the same conditions. Patterned wafer results (trench loss, active removal, and step height) are also shown in Table 1. Step height is listed in angstroms (Å) for two pattern features (in which the first number refers to the line width in microns and the second number refers to the pattern density).

**Table 1**

| Composition | Blanket TEOS RR | Trench Loss (Å) | Active Removal (Å) | Step Height L35-70 | Step Height L10-20 |
|---|---|---|---|---|---|
| 2A | 200 | 180 | 4045 | 275 | 30 |
| 2B | 2225 | 1776 | 6711 | 39 | 26 |

As is readily apparent from the results set forth in Table 1, the composition including the cubiform ceria abrasive particles (2B) achieved a 65 percent improvement in active removal and an improved step height (particular in the dense feature). However, these improvements were offset by a nearly 10x increase in trench loss. Owing to the high blanket removal rates and the high trench loss, composition 2B (including the cubiform ceria abrasive particles) is not a self-stopping composition. Based on this example, those of ordinary skill will readily appreciate that due to the complex interaction between the ceria abrasive and the composition chemistry, conventional wet ceria abrasive particles (as in 2A) cannot be swapped out with cubiform ceria abrasive particles (as in 2B) in self-stopping CMP compositions.

### EXAMPLE 3

Ten polishing compositions were tested to evaluate TEOS polishing rates and self-stopping behavior on patterned wafers. The ten polishing compositions (3A-3J) were selected to vary cationic polymer level and type and were compared to the control composition 1A. Each composition was prepared by combining an A pack with deionized water and a corresponding B pack. Each A pack included 3500 ppm by weight picolinic acid, 75 ppm by weight Kordex MLX, and 20 weight percent of the ceria dispersion described above in Example 1 (for a total ceria concentration of 2 weight percent in the A pack).

The B packs included 4000 ppm by weight triethanolamine, 1600 ppm by weight benzotriazole, cationic polymer, 1670 ppm by weight benzhydroxamic acid, and 113 ppm by weight Kordex MLX at pH 8.2. The cationic polymer types and amounts are listed below in Table 2A.

**Table 2A**

| Composition | Cationic Polymer | Amount in B Pack |
|---|---|---|
| 2A | polyMADQUAT | 250 ppm |
| 3A | polyMADQUAT | 500 ppm |
| 3B | polyMADQUAT | 750 ppm |
| 3C | poly(diallyldimethylammonium chloride-co-acrylamide) | 500 ppm |
| 3D | poly(diallyldimethylammonium chloride-co-acrylamide) | 750 ppm |
| 3E | polyquaternium-44 | 500 ppm |
| 3F | polyquaternium-44 | 750 ppm |
| 3G | polyDADMAC | 250 ppm |
| 3H | polyDADMAC | 125 ppm |
| 3I | poly(vinylimidazolium) methyl sulfate | 250 ppm |
| 3J | poly(vinylimidazolium) methyl sulfate | 125 ppm |

One part of the A pack was first combined with 6 parts deionized water and then further combined with 3 parts of the B pack to obtain point of use compositions that included 0.2 weight percent ceria abrasive, 350 ppm by weight picolinic acid, 1200 ppm by weight triethanolamine, 500 ppm by weight benzhydroxamic acid, and 480 ppm by weight benzotriazole. The point of use amounts of cationic polymer were 30 percent of the quantities listed in Table 2A. The pH of the combined A and B packs was about 7.8.

Blanket TEOS wafers were polished for 60 seconds on a Mirra^{®} tool at the conditions listed above. Blanket TEOS removal rates are shown in Table 2B in angstroms per minute (A/min). Patterned wafers were polished for 80 seconds on a Mirra^{®} tool at the same conditions. Patterned wafer results (trench loss, active removal, and step height) are also shown in Table 2B. Step height is listed in angstroms (Å) for two patterns (in which the first number refers to the line width in microns and the second number refers to the pattern density).

**Table 2B**

| Composition | Blanket TEOS RR | Trench Loss (Å) | Active Removal (Å) | Step Height L35-70 | Step Height L10-20 |
|---|---|---|---|---|---|
| 2A | 200 | 180 | 4045 | 275 | 30 |
| 3A | 587 | 1100 | 5885 | 66 | 23 |
| 3B | 153 | 323 | 4327 | 241 | 29 |
| 3C | 87 | 17 | 1642 | 3921 | |
| 3D | 42 | 3 | 337 | 4859 | 716 |
| 3E | 87 | 207 | 4114 | 375 | 57 |
| 3F | 59 | 63 | 2235 | 3712 | 165 |
| 3G | 2379 | 1019 | 5643 | 133 | 24 |
| 3H | 2747 | 1161 | 5942 | 101 | 25 |
| 3I | 4 | 2 | 13 | 5055 | >5000 |
| 3J | 7 | 5 | 2466 | 2685 | 772 |

As is readily apparent from the results set forth in Table 2B, compositions 3B and 3E including polyMADQUAT and Polyquaternium-44 cationic polymers provide excellent self-stopping performance. Moreover compositions 3C, 3F, and 3J provide an excellent ratio of active removal rate to both blanket removal rate and trench loss. With minor modifications these compositions may likewise also provide excellent self-stopping performance.

### EXAMPLE 4

Eight polishing compositions were tested to evaluate TEOS polishing rates and self-stopping behavior on patterned wafers. The eight polishing compositions (4A-4H) were selected to vary the self-stopping agent level and type and were compared to the control composition 2A. Each composition was prepared by combining an A pack with deionized water and a corresponding B pack. Each A pack included 3500 ppm by weight picolinic acid, 75 ppm by weight Kordex MLX, and 20 weight percent of the ceria dispersion described above in Example 1 (for a total ceria concentration of 2 weight percent in the A pack).

The B packs included 4000 ppm by weight triethanolamine, 1600 ppm by weight benzotriazole, 250 ppm by weight polyMADQUAT, self-stopping agent, and 113 ppm by weight Kordex MLX. The self-stopping agent types and amounts are listed below in Table 3A.

**Table 3A**

| Composition | Self-Stopping Agent | Amount in B Pack | pH of B Pack |
|---|---|---|---|
| 2A | Benzhydroxamic acid | 1670 ppm | 8.2 |
| 4A | Benzhydroxamic acid | 2505 ppm | 8.2 |
| 4B | Benzhydroxamic acid | 5010 ppm | 8.2 |
| 4C | Salicyhydroxamic acid | 835 ppm | 8.2 |
| 4D | Salicyhydroxamic acid | 3340 ppm | 8.2 |
| 4E | Kojic acid | 835 ppm | 5 |
| 4F | Kojic acid | 3340 ppm | 5 |
| 4G | Potassium Sorbate | 835 ppm | 6 |
| 4H | Potassium Sorbate | 3340 ppm | 6 |

One part of the A pack was first combined with 6 parts deionized water and then further combined with 3 parts of the B pack to obtain point of use compositions that included 0.2 weight percent ceria abrasive, 350 ppm by weight picolinic acid, 1200 ppm by weight triethanolamine, 75 ppm by weight polyMADQUAT, and 480 ppm by weight benzotriazole. The point of use amounts of self-stopping agent were 30 percent of the quantities listed in Table 3A. The pH of the combined A and B packs was about 7.8 for compositions 4A-4D and about 5.5 for compositions 4E-4H.

Blanket TEOS wafers were polished for 60 seconds on a Mirra^{®} tool at the conditions listed above. Blanket TEOS removal rates are shown in Table 3B in Angstroms per minute (A/min). Patterned wafers were polished for 80 seconds on a Mirra^{®} tool at the same conditions. Patterned wafer results (trench loss, active removal, and step height) are also shown in Table 3B. Step height is listed in angstroms (Å) for two patterns (in which the first number refers to the line width in microns and the second number refers to the pattern density).

**Table 3B**

| Composition | Blanket TEOS RR | Trench Loss (Å) | Active Removal (Å) | Step Height L35-70 | Step Height L10-20 |
|---|---|---|---|---|---|
| 2A | 200 | 180 | 4045 | 275 | 30 |
| 4A | 1126 | 1164 | 5980 | 216 | 39 |
| 4B | 471 | 491 | 5098 | 92 | 24 |
| 4C | 3088 | 2205 | 7086 | 40 | 22 |
| 4D | 634 | 686 | 5268 | 180 | 28 |
| 4E | 613 | 1094 | 5649 | 240 | 31 |
| 4F | 137 | 316 | 3808 | 1513 | 92 |
| 4G | 1551 | 2387 | 7314 | 59 | 18 |
| 4H | 386 | 631 | 4927 | 362 | 32 |

As is readily apparent from the results set forth in Table 3B, compositions 4B, 4D, and 4H including benzhydroxamic acid, saliclhydroxamic acid, and potassium sorbate self-stopping agents provide excellent self-stopping performance. Moreover, composition 4F (using a kojic acid self-stopping agent) provides an excellent ratio of active removal rate to both blanket removal rate and trench loss. With minor modifications this compositions may likewise also provide excellent self-stopping performance.

### EXAMPLE 5

Two polishing compositions were tested to evaluate TEOS polishing rates and self-stopping behavior on blanket and patterned wafers. Each composition was prepared by combining an A pack with deionized water and a corresponding B pack. The A packs included 3500 ppm by weight picolinic acid, 75 ppm by weight Kordex MLX, and 2 weight percent ceria abrasive at pH 4.0. For composition 5A, the ceria abrasive included 2 weight percent of a control ceria (a sintered ceria abrasive used in polishing composition 1C of commonly assigned U.S. Patent 9,505,952). For composition 5B, the ceria abrasive included one part by weight of the stock ceria dispersion described above in Example 1 and four parts by weight deionized water. The B packs were identical and included 4000 ppm by weight triethanolamine, 1600 ppm by weight benzotriazole, 250 ppm by weight polyMADQUAT, 3340 ppm by weight potassium sorbate, and 113 ppm by weight Kordex MLX at pH 6.

One part of the A pack was first combined with 6 parts deionized water and then further combined with 3 parts of the B pack to obtain point of use compositions that included 0.2 weight percent ceria abrasive, 350 ppm by weight picolinic acid, 1200 ppm by weight triethanolamine, 480 ppm by weight benzotriazole, 1000 ppm by weight potassium sorbate, and 75 ppm by weight polyMADQUAT. The pH of the combined A and B packs was about 5.5.

Blanket TEOS wafers were polished for 60 seconds on a Mirra^{®} tool at the conditions listed above. Blanket TEOS removal rates are shown in Table 4 in angstroms per minute (A/min). Patterned wafers were polished for 80 seconds on a Mirra^{®} tool at the same conditions. Patterned wafer results (trench loss, active removal, and step height) are also shown in Table 4.

**Table 4**

| Composition | Blanket TEOS RR | Trench Loss (Å) | Active Removal (Å) | Step Height L35-70 (Å) |
|---|---|---|---|---|
| 5A | 76 | 19 | 457 | NA |
| 5B | 386 | 631 | 4927 | 362 |

As is readily apparent from the results set forth in Table 4, the composition including the cubiform ceria abrasive particles (2B) achieved excellent self-stopping performance with an active to blanket removal ratio of greater than 12 and a step height of less than 400 Å on the dense feature. In contrast, the composition using the control ceria abrasive exhibited very low removal rates and provided no planarization of the patterned wafer.

### EXAMPLE 6

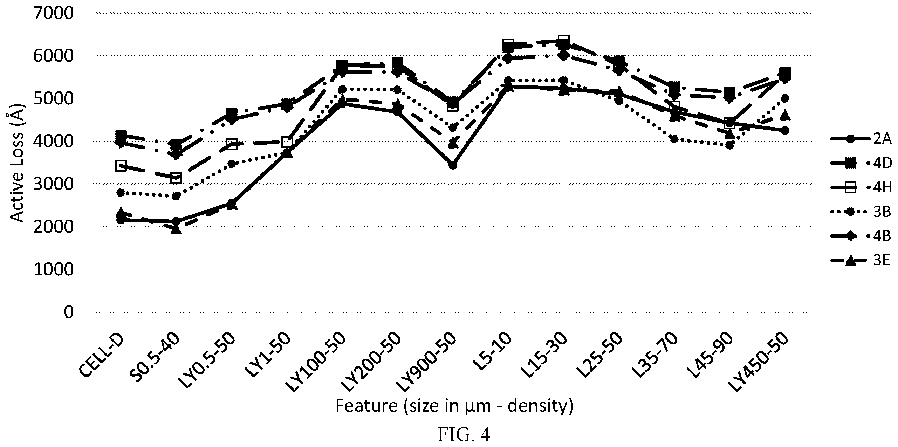

Six polishing compositions were tested to evaluate the active loss on patterned wafers across a wide range of patterns. As is known to those of ordinary skill in the art, active loss is defined as the active thickness prior to polishing minus the active thickness after polishing. The polishing compositions were identical to compositions 2A, 3B, 3E, 4B, 4D, and 4H. As indicated above, composition 2B included the control ceria abrasive while compositions 3B, 3E, 4B, 4D, and 4H included the cubiform ceria abrasive particles. The active loss is plotted in units of Å versus pattern type in FIG. 4.

As is readily apparent from the results set forth in FIG. 4, the compositions including the cubiform ceria abrasive particles achieve superior planarization as defined by a greater active loss across a wide range of pattern densities. Moreover, the compositions including the cubiform ceria abrasive particles also achieve superior planarization as defined by a difference between the maximum plotted active loss and the minimum plotted active loss across the range of pattern densities. Not wishing to be bound by theory it is believed that the cubiform ceria abrasive particles perform well with higher concentrations of self-stopping agent and/or cationic polymer and therefore achieve superior planarization.

### EXAMPLE 7

Two polishing compositions were tested to evaluate TEOS and SiN polishing rates and self-stopping behavior on blanket and patterned wafers. Each of compositions 7A, 7B, and 7C was prepared by combining an abrasive formulation (the A pack) and a corresponding additive formulation (the B pack) in a 7:3 volume ratio. The point of use pH for each composition was 6.2. The compositions of the abrasive formulations (the A packs) are shown in Table 5A while the compositions of the additive formulations (the B packs) are shown in Table 5B. All compositions are based on weight (e.g., weight percent or ppm by weight).

**Table 5A**

| A pack | Cubiform Ceria | Additive | pH |
|---|---|---|---|
| A1 | 0.71 wt. % | 500 ppm by weight picolinic acid | 4.2 |
| A2 | 0.71 wt. % | 31 ppm by weight *ε*-polylysine | 4.2 |

**Table 5B**

| B pack | Cationic Additive | Benzhydroxamic Acid | Additive 1 | Additive 2 | pH |
|---|---|---|---|---|---|
| B1 | NA | 0.50 wt. % | 0.4 wt. % Bis-Tris | NA | 7.0 |
| B2 | 70 ppm *ε-*polylysine | 0.50 wt. % | 0.4 wt. % Bis-Tris | 0.117 wt. % Crotonic Acid | 6.4 |
| B3 | 210 ppm *ε-*polylysine + 240 ppm DADMAC | 0.835 wt. % | 0.4 wt. % Bis-Tris | 0.117 wt. % Crotonic Acid | 6.4 |

Blanket TEOS and SiN wafers were polished for 60 seconds on a Applied Materials Reflexion ^{®} tool using at DuPont IC1010^{®} pad at a platen speed of 73 rpm, a head speed of 67 rpm, a downforce of 3.5 psi, and a slurry flow rate of 250 ml/min. Blanket TEOS and SiN removal rates are shown in Table 5C in angstroms per minute (Å/min). Patterned wafers were polished for 20 seconds on a Reflexion ^{®} tool at the same conditions. Patterned wafer results (trench loss and active removal) are also shown in Table 5C.

**Table 5C**

| Composition | A pack | B pack | Active Removal (Å) | Trench Loss (Å) | TEOS RR (Å/min) | SiN RR (Å/min) |
|---|---|---|---|---|---|---|
| 7A | A1 | B1 | 3923 | 163 | 1317 | 59 |
| 7B | A2 | B2 | 3977 | 281 | 42 | 27 |
| 7C | A2 | B3 | 1604 | 14 | 15 | 12 |

As is readily apparent from the data set forth in Table 5C, composition 7B exhibits excellent self-stopping performance with a high active removal (nearly 4000 Å) and a very low blanket removal rate to achieve an active to blanket removal ratio of nearly 100 and an active removal to trench loss ratio of 14. Composition 7C also exhibits excellent self-stopping performance albeit with a lower active removal. Composition 7C achieved active to blanket removal and active removal to trench loss ratios of greater than 100.

### EXAMPLE 8

Three polishing compositions were tested to evaluate the effect of lanthanum doping level in the cubiform ceria abrasive particles on the TEOS removal rate. Composition 8A included 0.28 weight percent of a control ceria (wet process ceria HC60^{™} commercially available from Rhodia). Composition 8B included 0.28 weight percent cubiform ceria abrasive particles including 2.5 mole percent lanthanum oxide and was prepared by diluting the stock ceria dispersion described above in Example 1 with 34 parts water to 1 part stock ceria dispersion. Composition 8C included 0.28 weight percent cubiform ceria abrasive particles including 10 mole percent lanthanum oxide and was prepared by diluting the ceria dispersion described in the following paragraphs with 34 parts water to 1 part ceria dispersion. Each of compositions 8A-8C had a pH of 4.

A cerium oxide dispersion was prepared as follows. A cerium nitrate solution was prepared by combining 11.5 kg of a 3M trivalent cerium(III) nitrate solution, 1.3 kg of a 3M lanthanum nitrate solution, 1.86 kg of a 68% nitric acid (HNO₃) solution, 0.5 kg deionized water, and cerium(IV) nitrate at a molar ratio of cerium(IV) to cerium(total) equal to 0.0000125 (1/80,235). The cerium nitrate solution was then degassed with agitation and nitrogen bubbling in a 20 L vessel.

An aqueous ammonia solution was prepared by combining 70 kg of deionized water and a solution of 14 kg of 25% aqueous ammonia (such that the molar ratio of NH₄OH in the aqueous ammonia solution to the total cerium and lanthanum in the cerium nitrate solution was 10). The aqueous ammonia solution was then degassed with agitation and nitrogen bubbling in a 100 L vessel jacketed reactor.

The cerium nitrate solution was then added, at ambient temperature, to the aqueous ammonia solution with the same agitation under nitrogen purging. The temperature of the reaction mixture was then increased to 88° C and held at that temperature for 13.5 hours. The reaction mixture was then left to cool and upon cooling was acidified to pH 2 by adding 68% nitric acid.

The reaction mixture was then filtrated and washed with deionized water. The washing was repeated when the conductivity of the washing solution was less than 0.04 mS/cm. Deionized water was added to adjust the final cubiform ceria abrasive concentration to 10 weight percent. The cubiform ceria abrasive particles included 10 mole percent lanthanum oxide and 90 mole percent cerium oxide.

The BET specific surface area was determined by nitrogen adsorption to be 8.6 m² per gram. The average particle size was 142 nm as measured by Malvern Zetasizer.

Blanket TEOS wafers were polished for 60 seconds on a Mirra^{®} tool at the conditions listed above. Polishing results are shown in Table 6. All removal rates (RR) are listed in angstroms per minute (Å/min).

**Table 6**

| Composition | Abrasive | TEOS RR |
|---|---|---|
| 8A | Control Ceria | 3819 |
| 8B | Cubiform Ceria with 2.5% La | 6388 |
| 8C | Cubiform Ceria with 10% La | 6285 |

As is readily apparent from the data set forth in Table 5, compositions 8B and 8C exhibited equivalent TEOS removal rates that are greater than 1.6x the removal rate of composition 8A.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein may be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein.

It will be understood that the disclosure includes numerous embodiments beyond those included above in the Examples. These embodiments include, but are not limited to the embodiments listed in the appended claims.

## Claims

1. A chemical mechanical polishing composition comprising:
a liquid carrier;
cubiform ceria abrasive particles dispersed in the liquid carrier;
a self-stopping agent; and
a cationic polymer.

2. The composition of claim 1, wherein the cubiform ceria abrasive particles comprise a mixture of cerium oxide and lanthanum oxide.

3. The composition of claim 1, wherein the cubiform ceria abrasive particles have a molar ratio of lanthanum to lanthanum plus cerium in a range from about 1 to about 15 percent.

4. The composition of claim 1, wherein any one or more of the following applies,
a) the cubiform ceria abrasive particles have a BET surface area in a range from about 3 m²/g to about 14 m²/g;
b) the cubiform ceria abrasive particles have an average particle size in a range from about 50 to about 500 nm; and
c) the composition comprising from about 0.01 weight percent to about 1 weight percent of the cubiform ceria abrasive particles.

5. The composition of claim1, wherein
a) the self-stopping agent is a ligand that is attached to the cubiform ceria abrasive particles; and/or
b) the self-stopping agent is kojic acid, maltol, ethyl maltol, propyl maltol, hydroxamic acid, benzhydroxamic acid, salicylhydroxamic acid, benzoic acid, 3,4-dihydroxybenzoic acid, 3,5-dihydroxybenzoic acid, caffeic acid, sorbic acid, potassium sorbate, and combinations thereof, wherein optionally the self-stopping agent is benzhydroxamic acid, salicylhydroxamic acid, kojic acid, potassium sorbate, or a combination thereof.

6. The composition of claim 1, wherein the cationic polymer is selected from the group consisting of poly(vinylimidazolium), poly(vinylimidazole), methacryloyloxyethyltrimethylammonium, poly(diallyldimethylammonium), Polyquaternium-2, Polyquaternium-11, Polyquaternium-16, Polyquaternium-46, Polyquaternium-44, polylysine, and combinations thereof, wherein optionally the cationic polymer is poly(vinylimidazolium), poly(vinylimidazole), methacryloyloxyethyltrimethylammonium, polylysine, or a combination thereof.

7. The composition of claim 1, wherein
a point of use concentration of the cubiform ceria abrasive particles is from about 0.01 weight percent to about 1 weight percent;
a point of use concentration of the self-stopping agent is from about 200 ppm by weight to about 5000 ppm by weight; and
a point of use concentration of the cationic polymer is from about 5 ppm by weight to about 500 ppm by weight.

8. The composition of claim 1, further comprising a carboxylic acid rate enhancer, wherein optionally the carboxylic acid rate enhancer is picolinic acid, acetic acid, 4-hydroxybenzoic acid, or a mixture thereof.

9. The composition of claim 1, further comprising an unsaturated carboxylic monoacid rate inhibitor selected from the group consisting of acrylic acid, crotonic acid, 2-pentenoic acid, trans-2-hexenoic acid, trans-3-hexenoic acid, 2-hexynoic acid, 2,4-hexadienoic acid, potassium sorbate, trans-2-methyl-2-butenoic acid, 3,3-dimethylacrylic acid, and combinations thereof, wherein optionally the unsaturated carboxylic monoacid rate inhibitor is crotonic acid.

10. The composition of claim 1, further comprising a non-polymeric cationic compound selected from the group consisting of 2-(dimethylamino)ethyl acrylate, 2-(dimethylamino)ethyl methacrylate, 3-(dimethylamino)propyl methacrylamide, 3-(dimethylamino)propyl acrylamide, lysine, 3-methacrylamidopropyl-trimethyl-ammonium, 3-acrylamidopropyl-trimethyl-ammonium, diallyldimethylammonium, 2-(acryloyloxy)-*N,N,N-*trimethylethanaminium, methacryloyloxyethyltrimethylammonium, *N,N-dimethylaminoethyl* acrylate benzyl, *N*,*N*-dimethylaminoethyl methacrylate benzyl, and combinations thereof, wherein optionally
a) the non-polymeric cationic compound comprises diallyldimethylammonium, methacryloyloxyethyltrimethylammonium, lysine, 2-(dimethylamino)ethyl methacrylate, or a mixture thereof; and/or
b) the cationic polymer comprises polylysine and the non-polymeric compound comprises diallyldimethylammonium.

11. The composition of claim 1, wherein any one or more of the following applies,
a) the composition further comprising triethanolamine;
b) the composition further comprising benzotriazole or bis tris methane; and
c) the composition having a pH in a range from about 5 to about 10.

12. The composition of claim 1, wherein:
the self-stopping agent is benzhydroxamic acid, salicylhydroxamic acid, kojic acid, potassium sorbate, or a combination thereof;
the cationic polymer is poly(vinylimidazolium), poly(methacryloyloxyethyl trimethylammonium), polylysine, poly(diallyldimethylammonium), or a combination thereof; and
the composition further comprises picolinic acid, acetic acid, 4-hydroxybenzoic acid, or a mixture thereof, wherein optionally any one or more of the following applies,
a) the composition further comprising triethanolamine and benzotriazole;
b) the self-stopping agent is benzhydroxamic acid, salicylhydroxamic acid, or a combination thereof and the pH is in a range from about 7 to about 9 at point of use, the composition optionally comprising at least 250 ppm by weight of the self-stopping agent at point of use and 50 ppm by weight of the cationic polymer at point of use; and
c) the self-stopping agent is kojic acid, potassium sorbate, or a combination thereof and the pH is in a range from about 5 to about 6.5 at point of use.

13. The composition of claim 1, wherein:
the self-stopping agent is benzhydroxamic acid, salicylhydroxamic acid, or a combination thereof; and
the cationic polymer is *ε*-poly-L-lysine, poly(vinylimidazolium), or a combination thereof, the composition optionally further comprising
a) crotonic acid; and/or
b) a non-polymeric cationic compound selected from the group consisting of diallyldimethylammonium, methacryloyloxyethyltrimethylammonium, lysine, 2-(dimethylamino)ethyl methacrylate, or a mixture thereof, wherein optionally the composition comprises
at least 250 ppm by weight of the self-stopping agent;
at least 20 ppm by weight of the cationic polymer; and
at least 20 ppm by weight of the non-polymeric cationic compound.

14. A method of chemical mechanical polishing a substrate including a silicon oxide dielectric material, the method comprising:
(a) providing a polishing composition including a liquid carrier, cubiform ceria abrasive particles dispersed in the liquid carrier, a self-stopping agent, and a cationic polymer;
(b) contacting the substrate with said provided polishing composition;
(c) moving said polishing composition relative to the substrate; and
(d) abrading the substrate to remove a portion of the silicon oxide dielectric material from the substrate and thereby polish the substrate.

15. The method of claim 14, wherein any one or more of the following applies,
a) a ratio of an active removal of the silicon oxide dielectric material in a patterned region of the substrate to a trench loss removal of the silicon oxide dielectric material is greater than about 5 in (d);
b) the self-stopping agent is benzhydroxamic acid, salicylhydroxamic acid, kojic acid, potassium sorbate, or a combination thereof;
the cationic polymer is poly(vinylimidazolium), poly(methacryloyloxyethyl trimethylammonium), polylysine, poly(diallyldimethylammonium), or a combination thereof; and
the polishing composition further comprises picolinic acid, acetic acid, 4-hydroxybenzoic acid, or a mixture thereof;
c) the self-stopping agent is benzhydroxamic acid, salicylhydroxamic acid, or a combination thereof;
the cationic polymer is *ε*-poly-L-lysine, poly(vinylimidazolium), or a combination thereof,
wherein optionally the polishing composition further comprises a non-polymeric cationic compound selected from the group consisting of diallyldimethylammonium, methacryloyloxyethyltrimethylammonium, lysine, 2-(dimethylamino)ethyl methacrylate, or a mixture thereof.

## Patentansprüche

1. Zusammensetzung zum chemisch-mechanischen Polieren, umfassend:
einen flüssigen Träger;
abrasive Partikel aus kubiformem Ceroxid, die in dem flüssigen Träger dispergiert sind; und
ein selbststoppendes Mittel; und
ein kationisches Polymer.

2. Zusammensetzung nach Anspruch 1, wobei die abrasiven Partikel aus kubiformem Ceroxid eine Mischung aus Ceroxid und Lanthanoxid umfassen.

3. Zusammensetzung nach Anspruch 1, wobei die abrasiven Partikel aus kubiformem Ceroxid ein Molverhältnis von Lanthan zu Lanthan plus Cer in einem Bereich von etwa 1 bis etwa 15 Prozent aufweisen.

4. Zusammensetzung nach Anspruch 1, wobei eines oder mehrere von Folgendem zutrifft/zutreffen:
a) die abrasiven Partikel aus kubiformem Ceroxid weisen eine BET-Oberfläche in einem Bereich von etwa 3 m²/g bis etwa 14 m²/g auf;
b) die abrasiven Partikel aus kubiformem Ceroxid weisen eine mittlere Partikelgröße in einem Bereich von etwa 50 bis etwa 500 nm auf; und
c) die Zusammensetzung umfasst etwa 0,01 Gewichtsprozent bis etwa 1 Gewichtsprozent der abrasiven Partikel aus kubiformem Ceroxid.

5. Zusammensetzung nach Anspruch 1, wobei
a) das selbststoppende Mittel ein Ligand ist, der an die abrasiven Partikel aus kubiformem Ceroxid gebunden ist; und/oder
b) das selbststoppende Mittel Kojisäure, Maltol, Ethylmaltol, Propylmaltol, Hydroxamsäure, Benzhydroxamsäure, Salicylhydroxamsäure, Benzoesäure, 3,4-Dihydroxybenzoesäure, 3,5-Dihydroxybenzoesäure, Coffeinsäure, Sorbinsäure, Kaliumsorbat und Kombinationen davon ist, wobei das selbststoppende Mittel gegebenenfalls Benzhydroxamsäure, Salicylhydroxamsäure, Kojisäure, Kaliumsorbat oder eine Kombination davon ist.

6. Zusammensetzung nach Anspruch 1, wobei das kationische Polymer ausgewählt ist aus der Gruppe bestehend aus Poly(vinylimidazolium), Poly(vinylimidazol), Methacryloyloxyethyltrimethylammonium, Poly(diallyldimethylammonium), Polyquaternium-2, Polyquaternium-11, Polyquaternium-16, Polyquaternium-46, Polyquaternium-44, Polylysin und Kombinationen davon, wobei das kationische Polymer gegebenenfalls Poly(vinylimidazolium), Poly(vinylimidazol), Methacryloyloxyethyltrimethylammonium, Polylysin oder eine Kombination davon ist.

7. Zusammensetzung nach Anspruch 1, wobei
eine Einsatzpunktkonzentration der abrasiven Partikel aus kubiformem Ceroxid etwa 0,01 Gewichtsprozent bis etwa 1 Gewichtsprozent beträgt;
eine Einsatzpunktkonzentration des selbststoppenden Mittels etwa 200 Gew.-ppm bis etwa 5000 Gew.-ppm beträgt; und
eine Einsatzpunktkonzentration des kationischen Polymers etwa 5 Gew.-ppm bis etwa 500 Gew.-ppm beträgt.

8. Zusammensetzung nach Anspruch 1, ferner umfassend einen Carbonsäure-Ratenverbesserer, wobei gegebenenfalls der Carbonsäure-Ratenverbesserer Picolinsäure, Essigsäure, 4-Hydroxybenzoesäure oder eine Mischung davon ist.

9. Zusammensetzung nach Anspruch 1, ferner umfassend einen ungesättigten Monocarbonsäure-Rateninhibitor ausgewählt aus der Gruppe bestehend aus Acrylsäure, Crotonsäure, 2-Pentensäure, trans-2-Hexensäure, trans-3-Hexensäure, 2-Hexinsäure, 2,4-Hexadiensäure, Kaliumsorbat, trans-2-Methyl-2-butensäure, 3,3-Dimethylacrylsäure und Kombinationen davon, wobei gegebenenfalls der ungesättigte Monocarbonsäure-Rateninhibitor Crotonsäure ist.

10. Zusammensetzung nach Anspruch 1, ferner umfassend eine nicht-polymere kationische Verbindung ausgewählt aus der Gruppe bestehend aus 2-(Dimethylamino)ethylacrylat, 2-(Dimethylamino)ethylmethacrylat, 3-(Dimethylamino)propylmethacrylamid, 3-(Dimethylamino)propylacrylamid, Lysin, 3-Methacrylamidopropyl-trimethylammonium, 3-Acrylamidopropyl-trimethylammonium, Diallyldimethylammonium, 2-(Acryloyloxy)-N,N,N-trimethylethanaminium, Methacryloyloxyethyltrimethylammonium, N,N-Dimethylaminoethylacrylat-Benzyl, N,N-Dimethylaminoethylmethacrylat-Benzyl und Kombinationen davon, wobei gegebenenfalls
a) die nicht-polymere kationische Verbindung Diallyldimethylammonium, Methacryloyloxyethyltrimethylammonium, Lysin, 2-(Dimethylamino)ethylmethacrylat oder eine Mischung davon umfasst; und/oder
b) das kationische Polymer Polylysin umfasst, und die nicht-polymere Verbindung Diallyldimethylammonium umfasst.

11. Zusammensetzung nach Anspruch 1, wobei eines oder mehrere von Folgendem zutrifft/zutreffen:
a) die Zusammensetzung umfasst ferner Triethanolamin;
b) die Zusammensetzung umfasst ferner Benzotriazol oder Bis-Tris-Methan; und
c) die Zusammensetzung hat einen pH-Wert in einem Bereich von etwa 5 bis etwa 10.

12. Zusammensetzung nach Anspruch 1, wobei:
das selbststoppende Mittel Benzhydroxamsäure, Salicylhydroxamsäure, Kojisäure, Kaliumsorbat oder eine Kombination davon ist;
das kationische Polymer Poly(vinylimidazolium), Poly(methacryloyloxyethyltrimethylammonium), Polylysin, Poly(diallyldimethylammonium) oder eine Kombination davon ist; und
die Zusammensetzung ferner Picolinsäure, Essigsäure, 4-Hydroxybenzoesäure oder eine Mischung davon umfasst, wobei gegebenenfalls eines oder mehrere von Folgendem zutrifft/zutreffen:
a) die Zusammensetzung umfasst ferner Triethanolamin und Benzotriazol;
b) das selbststoppende Mittel ist Benzhydroxamsäure, Salicylhydroxamsäure oder eine Kombination davon, und der pH-Wert liegt am Einsatzpunkt in einem Bereich von etwa 7 bis etwa 9, wobei die Zusammensetzung gegebenenfalls mindestens 250 Gew.-ppm des selbststoppenden Mittels am Einsatzpunkt und 50 Gew.-ppm des kationischen Polymers am Einsatzpunkt umfasst; und
c) das selbststoppende Mittel ist Kojisäure, Kaliumsorbat oder eine Kombination davon, und der pH-Wert am Einsatzpunkt liegt in einem Bereich von etwa 5 bis etwa 6,5.

13. Zusammensetzung nach Anspruch 1, wobei:
das selbststoppende Mittel Benzhydroxamsäure, Salicylhydroxamsäure oder eine Kombination davon ist; und
das kationische Polymer ε-Poly-L-Lysin, Poly(vinylimidazolium) oder eine Kombination davon ist, wobei die Zusammensetzung gegebenenfalls ferner umfasst:
a) Crotonsäure; und/oder
b) eine nicht-polymere kationische Verbindung ausgewählt aus der Gruppe bestehend aus Diallyldimethylammonium,
Methacryloyloxyethyltrimethylammonium, Lysin, 2-(Dimethylamino)ethylmethacrylat oder einer Mischung davon, wobei die Zusammensetzung gegebenenfalls umfasst:
mindestens 250 Gew.-ppm des selbststoppenden Mittels;
mindestens 20 Gew.-ppm des kationischen Polymers; und
mindestens 20 Gew.-ppm der nicht-polymeren kationischen Verbindung.

14. Verfahren zum chemisch-mechanischen Polieren eines Substrats, das ein dielektrisches Siliciumoxidmaterial einschließt, wobei das Verfahren umfasst:
(a) Bereitstellen einer Polierzusammensetzung, die einen flüssigen Träger, in dem flüssigen Träger dispergierte abrasive Partikel aus kubiformem Ceroxid, ein selbststoppendes Mittel und ein kationisches Polymer einschließt;
(b) Inkontaktbringen des Substrats mit der bereitgestellten Polierzusammensetzung;
(c) Bewegen der Polierzusammensetzung relativ zu dem Substrat; und
(d) Abradieren des Substrats zum Entfernen eines Teils des dielektrischen Siliciumoxidmaterials von dem Substrat, und dadurch Polieren des Substrats.

15. Verfahren nach Anspruch 14, wobei eines oder mehrere von Folgendem zutrifft/zutreffen:
a) ein Verhältnis einer aktiven Entfernung des dielektrischen Siliciumoxidmaterials in einer strukturierten Region des Substrats zu einer Grabenverlustentfernung des dielektrischen Siliciumoxidmaterials ist größer als etwa 5 in (d);
b) das selbststoppende Mittel ist Benzhydroxamsäure, Salicylhydroxamsäure, Kojisäure, Kaliumsorbat oder eine Kombination davon;
das kationische Polymer Poly(vinylimidazolium), Poly(methacryloyloxyethyltrimethylammonium), Polylysin, Poly(diallyldimethylammonium) oder eine Kombination davon ist; und
die Polierzusammensetzung umfasst ferner Picolinsäure, Essigsäure, 4-Hydroxybenzoesäure oder eine Mischung davon;
c) das selbststoppende Mittel ist Benzhydroxamsäure, Salicylhydroxamsäure oder eine Kombination davon;
das kationische Polymer ist ε-Poly-L-Lysin, Poly(vinylimidazolium) oder eine Kombination davon,
wobei gegebenenfalls die Polierzusammensetzung ferner eine nicht-polymere kationische Verbindung ausgewählt aus der Gruppe bestehend aus Diallyldimethylammonium, Methacryloyloxyethyltrimethylammonium, Lysin, 2-(Dimethylamino)ethylmethacrylat oder einer Mischung davon umfasst.

## Revendications

1. Composition de polissage mécano-chimique comprenant :
un support liquide ;
des particules abrasives cubiformes d'oxyde de cérium dispersées dans le support liquide ;
un agent auto-stoppant ; et
un polymère cationique.

2. Composition selon la revendication 1, dans laquelle les particules abrasives cubiformes d'oxyde de cérium comprennent un mélange d'oxyde de cérium et d'oxyde de lanthane.

3. Composition selon la revendication 1, dans laquelle les particules abrasives cubiformes d'oxyde de cérium ont un rapport molaire du lanthane sur lanthane plus cérium dans une plage d'environ 1 à environ 15 pour cent.

4. Composition selon la revendication 1, dans laquelle un ou plusieurs des énoncés suivants s'appliquent,
a) les particules abrasives cubiformes d'oxyde de cérium ont une surface BET dans une plage d'environ 3 m²/g à environ 14 m²/g ;
b) les particules abrasives cubiformes d'oxyde de cérium ont une taille moyenne de particule dans une plage d'environ 50 à environ 500 nm ; et
c) la composition comprenant d'environ 0,01 pour cent en poids à environ 1 pour cent en poids des particules abrasives cubiformes d'oxyde de cérium.

5. Composition selon la revendication 1, dans laquelle a) l'agent auto-stoppant est un ligand qui est fixé aux particules abrasives cubiformes d'oxyde de cérium ; et/ou b) l'agent auto-stoppant est l'acide kojique, le maltol, l'éthylmaltol, le propylmaltol, l'acide hydroxamique, l'acide benzhydroxamique, l'acide salicylhydroxamique, l'acide benzoïque, l'acide 3,4-dihydroxybenzoïque, l'acide 3,5-dihydroxybenzoïque, l'acide caféique, l'acide sorbique, le sorbate de potassium, et leurs combinaisons, dans laquelle éventuellement l'agent auto-stoppant est l'acide benzhydroxamique, l'acide salicylhydroxamique, l'acide kojique, le sorbate de potassium, ou une combinaison de ceux-ci.

6. Composition selon la revendication 1, dans laquelle le polymère cationique est choisi dans le groupe constitué par un poly(vinylimidazolium), un poly(vinylimidazole), un méthacryloyloxyéthyltriméthylammonium, un poly(diallyldiméthylammonium), un polyquaternium-2, un polyquaternium-11, un polyquaternium-16, un polyquaternium-46, un polyquaternium-44, une polylysine et des combinaisons de ceux-ci, dans laquelle le polymère cationique est éventuellement un poly(vinylimidazolium), un poly(vinylimidazole), un méthacryloyloxyéthyltriméthylammonium, une polylysine ou une combinaison de ceux-ci.

7. Composition selon la revendication 1, dans laquelle une concentration au point d'utilisation des particules abrasives cubiformes d'oxyde de cérium est d'environ 0,01 pour cent en poids à environ 1 pour cent en poids ;
une concentration au point d'utilisation de l'agent auto-stoppant est d'environ 200 ppm en poids à environ 5 000 ppm en poids ; et
une concentration au point d'utilisation du polymère cationique est d'environ 5 ppm en poids à environ 500 ppm en poids.

8. Composition selon la revendication 1, comprenant en outre un agent améliorant la vitesse de type acide carboxylique, dans laquelle éventuellement l'agent améliorant la vitesse de type acide carboxylique est l'acide picolinique, l'acide acétique, l'acide 4-hydroxybenzoïque ou un mélange de ceux-ci.

9. Composition selon la revendication 1, comprenant en outre un inhibiteur de vitesse de type monoacide carboxylique insaturé choisi dans le groupe constitué par l'acide acrylique, l'acide crotonique, l'acide 2-penténoïque, l'acide trans-2-hexénoïque, l'acide trans-3-hexénoïque, l'acide 2-hexynoïque, l'acide 2,4-hexadiénoïque, le sorbate de potassium, l'acide trans-2-méthyl-2-buténoïque, l'acide 3,3-diméthylacrylique, et des combinaisons de ceux-ci, éventuellement l'inhibiteur de vitesse de type mono acide carboxylique étant l'acide crotonique.

10. Composition selon la revendication 1, comprenant en outre un composé cationique non polymérique choisi dans le groupe constitué par l'acrylate de 2-(diméthylamino)éthyle, le méthacrylate de 2-(diméthylamino)éthyle, le méthacrylamide de 3-(diméthylamino)propyle, l'acrylamide de 3-(diméthylamino)propyle, la lysine, le 3-méthacrylamidopropyl-triméthylammonium, le 3-acrylamidopropyl-triméthylammonium, le diallyldiméthylammonium, le 2-(acryloyloxy)-N,N,N-triméthyléthanaminium, le méthacryloyloxyéthyltriméthylammonium, l'acrylate de N,N-diméthylaminoéthyle benzyle, le méthacrylate de N,N-diméthylaminoéthyle benzyle et leurs combinaisons, dans laquelle éventuellement
a) le composé cationique non polymérique comprend le diallyldiméthylammonium, le méthacryloyloxyéthyltriméthylammonium, la lysine, le méthacrylate de 2-(diméthylamino)éthyle, ou un mélange de ceux-ci ; et/ou
b) le polymère cationique comprend une polylysine et le composé non polymérique comprend le diallyldiméthylammonium.

11. Composition selon la revendication 1, dans laquelle un ou plusieurs des énoncés suivants s'appliquent,
a) la composition comprenant en outre de la triéthanolamine ;
b) la composition comprenant en outre du benzotriazole ou du bis tris méthane ; et
c) la composition ayant un pH dans une plage d'environ 5 à environ 10.

12. Composition selon la revendication 1, dans laquelle :
l'agent auto-stoppant est l'acide benzhydroxamique, l'acide salicylhydroxamique, l'acide kojique, le sorbate de potassium, ou une combinaison de ceux-ci ;
le polymère cationique est le poly(vinylimidazolium), le poly(méthacryloyloxyéthyltriméthylammonium), la polylysine, le poly(diallyldiméthylammonium), ou une combinaison de ceux-ci ; et
la composition comprend en outre de l'acide picolinique, de l'acide acétique, de l'acide 4-hydroxybenzoïque ou un mélange de ceux-ci, dans laquelle éventuellement l'un quelconque ou plusieurs des énoncés suivants s'appliquent,
a) la composition comprenant en outre de la triéthanolamine et du benzotriazole ;
b) l'agent auto-stoppant est l'acide benzhydroxamique, l'acide salicylhydroxamique ou une combinaison de ceux-ci et le pH est dans une plage d'environ 7 à environ 9 au point d'utilisation, la composition comprenant éventuellement au moins 250 ppm en poids de l'agent auto-stoppant au point d'utilisation et 50 ppm en poids du polymère cationique au point d'utilisation ; et
c) l'agent auto-stoppant est l'acide kojique, le sorbate de potassium ou une combinaison de ceux-ci et le pH est dans une plage d'environ 5 à environ 6,5 au point d'utilisation.

13. Composition selon la revendication 1, dans laquelle :
l'agent auto-stoppant est l'acide benzhydroxamique, l'acide salicylhydroxamique, ou une combinaison de ceux-ci ; et
le polymère cationique est la ε-poly-L-lysine, le poly(vinylimidazolium) ou une combinaison de ceux-ci, la composition comprenant éventuellement en outre
a) de l'acide crotonique ; et/ou
b) un composé cationique non polymérique choisi dans le groupe constitué par diallyldiméthylammonium, méthacryloyloxyéthyltriméthylammonium, lysine, méthacrylate de 2-(diméthylamino)éthyle, ou un mélange de ceux-ci, la composition comprenant éventuellement au moins 250 ppm en poids de l'agent auto-stoppant ;
au moins 20 ppm en poids du polymère cationique ; et
au moins 20 ppm en poids du composé cationique non polymérique.

14. Procédé de polissage mécano-chimique d'un substrat comprenant un matériau diélectrique d'oxyde de silicium, le procédé comprenant :
(a) la fourniture d'une composition de polissage comprenant un support liquide, des particules abrasives cubiformes d'oxyde de cérium dispersées dans le support liquide, un agent auto-stoppant et un polymère cationique ;
(b) la mise en contact du substrat avec ladite composition de polissage fournie ;
(c) le déplacement de ladite composition de polissage par rapport au substrat ; et
(d) l'abrasion du substrat pour éliminer une partie du matériau diélectrique d'oxyde de silicium du substrat et ainsi polir le substrat.

15. Procédé selon la revendication 14, dans lequel l'un quelconque ou plusieurs des énoncés suivants s'appliquent,
a) un rapport entre une élimination active du matériau diélectrique d'oxyde de silicium dans une zone à motifs du substrat sur une élimination de perte de tranchée du matériau diélectrique d'oxyde de silicium est supérieur à environ 5 en (d) ;
b) l'agent auto-stoppant est l'acide benzhydroxamique, l'acide salicylhydroxamique, l'acide kojique, le sorbate de potassium, ou une combinaison de ceux-ci ;
le polymère cationique est le poly(vinylimidazolium), le poly(méthacryloyloxyéthyltriméthylammonium), la polylysine, le poly(diallyldiméthylammonium), ou une combinaison de ceux-ci ; et
la composition de polissage comprend en outre de l'acide picolinique, de l'acide acétique, de l'acide 4-hydroxybenzoïque, ou un mélange de ceux-ci ;
c) l'agent auto-stoppant est l'acide benzhydroxamique, l'acide salicylhydroxamique, ou une combinaison de ceux-ci ;
le polymère cationique est la ε-poly-L-lysine, le poly(vinylimidazolium), ou combinaison de ceux-ci,
dans lequel éventuellement la composition de polissage comprend en outre un composé cationique non polymérique choisi dans le groupe constitué par le diallyldiméthylammonium, le méthacryloyloxyéthyltriméthylammonium, la lysine, le méthacrylate de 2-(diméthylamino)éthyle ou un mélange de ceux-ci.
